# EUROPEAN PATENT SPECIFICATION

(11) **EP 4 521 858 B1**
(45) Date of publication and mention of the grant of the patent: **02.09.2026**
(21) Application number: 24772196.2
(22) Date of filing: 19.07.2024
(51) Int. Cl.: H05K 1/14, H01R 12/77, H01R 13/24, H01Q 1/24, H04M 1/02, H01B 7/08

(54) **ELECTRONIC DEVICE COMPRISING FLEXIBLE CIRCUIT BOARD**
ELEKTRONISCHE VORRICHTUNG MIT FLEXIBLER LEITERPLATTE
DISPOSITIF ÉLECTRONIQUE COMPRENANT UNE CARTE DE CIRCUIT IMPRIMÉ SOUPLE

(30) Priority: 19.07.2023 KR 20230093981; 21.09.2023 KR 20230126520
(43) Date of publication of application: 12.03.2025
(73) Proprietor: Samsung Electronics Co., Ltd, Suwon-si, Gyeonggi-do 16677 (KR)
(72) Inventor: KIM, Joohan, Suwon-si Gyeonggi-do 16677 (KR); KIM, Soojung, Suwon-si Gyeonggi-do 16677 (KR); LEE, Muyeol, Suwon-si Gyeonggi-do 16677 (KR); JANG, Hyeyeon, Suwon-si Gyeonggi-do 16677 (KR)
(74) Representative: HGF
(86) International application number: PCT/KR2024/010478
(87) International publication number: WO 2025/018844

(56) References cited:
- KR-A- 20220 076 257
- KR-A- 20220 131 047
- KR-A- 20230 007 692
- KR-A- 20230 076 605
- US-A1- 2020 076 056

## Description

### [Technical Field]

Various embodiments disclosed herein relate to an electronic device and, more specifically, to an electronic device including a flexible printed circuit board.

### [Background Art]

An electronic device may include a conducting wire configured to transmit a signal or supply power. Inside the electronic device, the conducting wire may exist, for example, in the form of a cable and/or wiring on a circuit board. In various embodiments, the electronic device may include a flat cable (for example, a flexible flat cable (FFC) implemented as a flexible printed circuit board (FPCB)) in order to minimize a size (for example, a thickness) of the electronic device.

The electronic device may include an antenna for wireless communication and a wireless communication module configured to perform a communication operation in a radio frequency band through the antenna. The wireless communication module and the antenna may be connected to each other by the above-described conducting wire (for example, a flexible circuit board). For example, a contact terminal is disposed at a distal end of the conducting wire, and the contact terminal and the antenna are in contact with each other, so that the antenna and the wireless communication module are electrically connected to each other by the conducting wire.
KR 2023 0007692 relates to an electronic device including an array antenna.
KR 2022 0076257 relates to an electronic device including a reinforcing member.

### [Disclosure of Invention]

### [Solution to Problem]

The present invention is defined by the independent claim. Further aspects of the present invention are outlined in the dependent claims. As a component (for example, a camera) disposed in an electronic device becomes larger and an internal space of the electronic device becomes tighter, it is becoming increasingly difficult to connect an antenna and a wireless communication module through a printed circuit board. Accordingly, when connecting a highly flexible circuit board having a relatively small thickness or a flexible flat cable to the antenna, a repulsive force applied by a
contact member (for example, a C-clip terminal) to the antenna may cause the contact member or the flexible circuit board to be pushed out and moved. Accordingly, the electrical contact between the contact member and the antenna becomes poor, so that the quality of a signal transmitted or received by the wireless communication module through the antenna may deteriorate.

Various embodiments disclosed herein may provide an electronic device which has an improved electrical connection between a communication module and an antenna and more efficiently uses an internal space of the electronic device.

The technical tasks to be achieved herein may not be limited to the above-mentioned technical tasks, and other technical tasks not mentioned may be understood, through the following descriptions, by those skilled in the art to which the disclosure belongs.

An electronic device according to various embodiments of the disclosure may include: a frame including at least one antenna and having a metal material and a polymer material; a front plate coupled to the frame; a rear plate coupled to the frame in an opposite direction to the front plate; at least one electrical component at least partially disposed in an internal space defined by the frame, the front plate, and the rear plate; a printed circuit board disposed in the internal space; a flexible printed circuit board having a first end portion electrically connected to the printed circuit board and a second end portion extending to be adjacent to the at least one antenna; and a contact member which is disposed in the other end portion of the flexible printed circuit board, in electrical contact with the at least one antenna, and oriented to apply an elastic force in a direction parallel to a surface of the flexible printed circuit board. The flexible printed circuit board may extend along one surface of the electrical component within the internal space and include a protrusion portion formed by increasing a width of the flexible printed circuit board in an area adjacent to the other end portion.

Advantageously, the protrusion portion restricts, reduces or prevents a movement of the flexible printed circuit board when a reaction force acts on the flexible printed circuit board. The flexible printed circuit board therefore remains in substantially a same position, so an electrical contact of the contact member with the at least one antenna is not degraded, or is only minimally degraded. The electrical contact of the contact member with the at least one antenna is therefore better when the electronic device comprises a protrusion portion, compared with electronic devices which do not comprise the protrusion portion.

In various embodiments, the frame may include: a lateral frame positioned on a lateral surface of the electronic device and including a plurality of metal segments and a polymer injection portion coupled to the metal segments; and a support member coupled to the lateral frame and extending from the lateral frame into an inside of the electronic device, wherein the at least one antenna is at least one of the plurality of metal segments.

In various embodiments, the flexible printed circuit board may extend through a portion between the support member and the one surface of the electrical component.

In various embodiments, the support member may include a catching protrusion formed to allow the protrusion portion to be caught thereby in an area of the support member corresponding to the protrusion portion.

In various embodiments, the electronic device may include a fixing member positioned in a first direction perpendicular to the surface of the flexible printed circuit board from the contact member and configured to fix the contact member with respect to the first direction. When the contact member contacts with the at least one antenna, and the protrusion portion prevents or reduces a movement of the flexible printed circuit board caused by a reaction force of the contacting, the flexible printed circuit board may flex, bend or move in a direction perpendicular to a direction of the reaction force (and therefore perpendicular to the surface of the flexible printed circuit board. Advantageously, the fixing member prevents this movement of the flexible circuit board in the direction perpendicular to the surface of the flexible printed circuit board. The flexible circuit board therefore remains at least substantially in a same position, so the electrical contacts of the flexible circuit board with other components of the electronic device remain stable.

In various embodiments, the electrical component may include a flange extending to be positioned in the first direction with respect to the fixing member, and the flange may fix the fixing member with respect to the first direction.

In various embodiments, the fixing member may include a flange groove having a shape corresponding to the flange, and the flange may be inserted into the flange groove.

In various embodiments, the lateral frame may include a fixing groove formed in an area where the contact member is in contact with the at least one antenna and having a shape at least partially corresponding to the fixing member, and the fixing member may be fixed by being inserted into the fixing groove.

In various embodiments, a dimension of the fixing member may be configured so that the fixing member is fixedly fitted through an interference fit in an inner surface of the fixing groove.

In various embodiments, the fixing groove may be formed by partially removing the polymer material to expose a surface of the antenna facing an inside of the electronic device in an area where the contact member is in contact with the at least one antenna, and the fixing member may be configured to reinforce rigidity of the area where the polymer material has been partially removed by interference-fitting the fixing member to an inner surface of the fixing groove.

In various embodiments, the electronic device may include an adhesive member which is positioned between the fixing member and the contact member, is adhered to the fixing member and the contact member, and has an elastic material.

In various embodiments, the flexible printed circuit board may extend through a portion between the rear plate and one surface of the electrical component facing the rear plate.

In various embodiments, the flexible printed circuit board may extend through a portion between the lateral frame and one surface of the electrical component facing the lateral frame.

In various embodiments, the lateral frame may have a polygonal shape, and the flexible printed circuit board may extend along one side of the polygonal shape. The second end portion of the flexible printed circuit board may be positioned at a corner portion of the polygonal shape of the lateral frame, and the contact member may be oriented to apply an elastic force to a surface of another side which meets the side at the corner portion of the polygonal shape.

An electronic device according to various embodiments of the disclosure may include: a housing including at least one metal segment disposed on a lateral surface thereof and having an internal space; a support member extending from the lateral surface of the housing into the internal space; at least one electrical component which is at least partially disposed in the internal space; a wireless communication module positioned in the internal space; a flexible printed circuit board having a first end portion electrically connected to the wireless communication module and a second end portion extending to be adjacent to the at least one antenna; and a contact member which is disposed in the second end portion of the flexible printed circuit board, in electrical contact with the at least one antenna, and oriented to apply an elastic force in a direction parallel to a surface of the flexible printed circuit board.

The flexible printed circuit board may extend so that the second end portion is adjacent to the metal segment between the support member and one surface of the electrical component facing the support member, and include a protrusion portion formed by increase of a width of a part of the flexible printed circuit board adjacent to the second end portion, and the support member may include a catching protrusion positioned in an area corresponding to the protrusion portion and formed to allow the protrusion portion to be caught thereby.

In various embodiments, the electronic device may include a fixing member positioned in a first direction perpendicular to the surface of the flexible printed circuit board from the contact member and configured to fix the contact member with respect to the first direction.

In various embodiments, the electrical component may include a flange extending to be positioned in the first direction with respect to the fixing member and the flange may fix the fixing member with respect to the first direction.

In various embodiments, the housing may include a fixing groove formed in an area where the contact member is in contact with the at least one antenna and having a shape at least partially corresponding to the fixing member. The fixing member may be fixed by being inserted into the fixing groove.

In various embodiments, a dimension of the fixing member may be configured so that the fixing member is fixedly fitted through an interference fit in an inner surface of the fixing groove.

A flexible printed circuit board according to various embodiments of the disclosure is a flexible printed circuit board of an electronic device, and the electronic device may include: a housing including at least one metal segment disposed on a lateral surface thereof and having an internal space; a support member extending from the lateral surface of the housing into the internal space; a wireless communication module positioned in the internal space; and a catching protrusion formed in an area of the support member adjacent to the metal segment. The flexible printed circuit board may include: a connector disposed in first end portion of the flexible printed circuit board and configured to be electrically connected to the communication module; a contact member disposed in the second end portion of the flexible printed circuit board and including a pin configured to apply an elastic force in a direction parallel to a surface of the flexible printed circuit board; and a protrusion portion formed by increase of a width of an area of the flexible printed circuit board adjacent to the second end portion, and formed to be caught by the catching protrusion.

Various embodiments disclosed herein may provide an electronic device in which a wireless communication module and an antenna are connected to each other by a flexible printed circuit board to effectively use an internal space of the electronic device. A protrusion portion formed on a distal end of the flexible printed circuit board limits pushing of the flexible printed circuit board, so as to maintain a good electrical contact between the antenna and a contact member.

In addition, effects obtainable or expected due to various embodiments of this document may be directly or implicitly disclosed in the detailed description of the embodiments of this document.

### [Brief Description of Drawings]

In relation to the description of drawings, the same or similar reference numerals may be used for the same or similar components.
FIG. 1 is a block diagram of an electronic device in a network environment, according to an embodiment;
FIG. 2 is a front perspective view of an electronic device according to an embodiment;
FIG. 3 is a rear perspective view of an electronic device according to an embodiment;
FIG. 4 is an exploded perspective view of an electronic device according to an embodiment;
FIG. 5A is an exploded perspective view of a part of an electronic device according to various embodiments;
FIG. 5B is a cross-sectional view of an electronic device according to various embodiments;
FIG. 6A is a perspective view showing a flexible printed circuit board according to various embodiments;
FIG. 6B is a perspective view showing a contact member according to various embodiments;
FIG. 6C is a front view showing a contact member according to various embodiments;
FIG. 6D is a side view showing a contact member according to various embodiments;
FIG. 7A is a plan view showing a frame and a flexible printed circuit board according to various embodiments of the disclosure;
FIG. 7B is a cross-sectional view showing a frame and a flexible printed circuit board according to various embodiments of the disclosure;
FIG. 8A is a perspective view of an electronic device according to various embodiments;
FIG. 8B is a cross-sectional view of an electronic device according to various embodiments;
FIG. 8C is a perspective view of a fixing member according to various embodiments;
FIG. 8D is a perspective view of an electronic device according to various embodiments;
FIG. 8E is a cross-sectional view of an electronic device according to various embodiments;
FIG. 9A is a cross-sectional view of an electronic device according to various embodiments; and
FIG. 9B is an internal plan view of an electronic device according to various embodiments.

### [Mode for the Invention]

Hereinafter, various embodiments of this document are described with reference to the attached drawings.

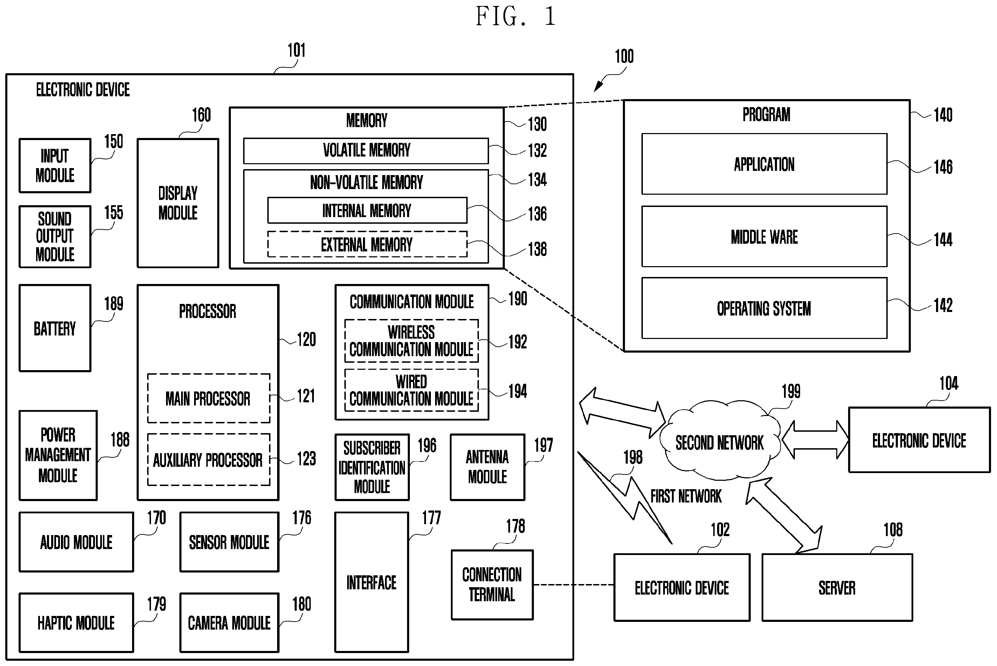

Fig. 1 is a block diagram illustrating an electronic device 101 in a network environment 100 according to various embodiments.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input 1module 150, a sound output 1module 155, a display 1module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display 1module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input 1module 150 may receive a command or data to be used by another component (e.g., the processor 120) of the electronic device 101, from the outside (e.g., a user) of the electronic device 101. The input 1module 150 may include, for example, a microphone, a mouse, a keyboard, a key (e.g., a button), or a digital pen (e.g., a stylus pen).

The sound output 1module 155 may output sound signals to the outside of the electronic device 101. The sound output 1module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display 1module 160 may visually provide information to the outside (e.g., a user) of the electronic device 101. The display 1module 160 may include, for example, a display, a hologram device, or a projector and control circuitry to control a corresponding one of the display, hologram device, and projector. According to an embodiment, the display 1module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input 1module 150, or output the sound via the sound output 1module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is
referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

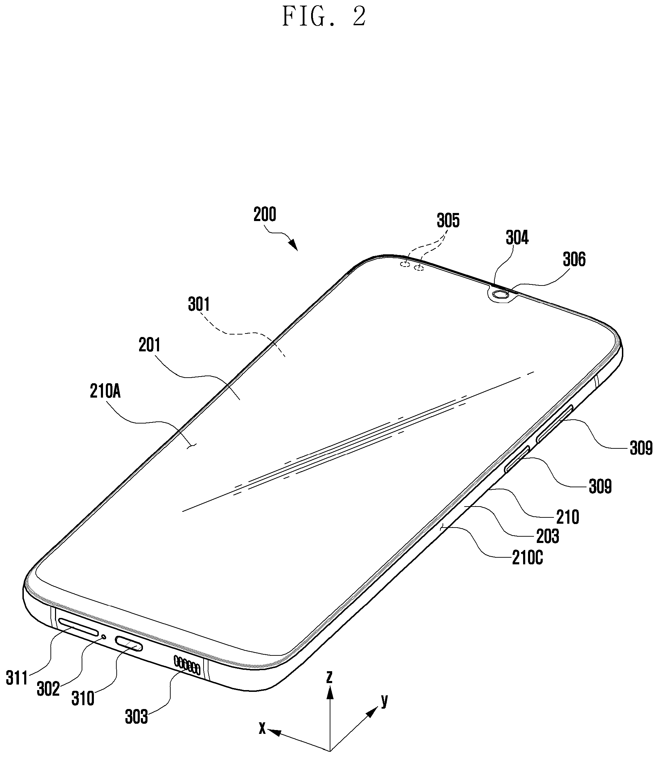

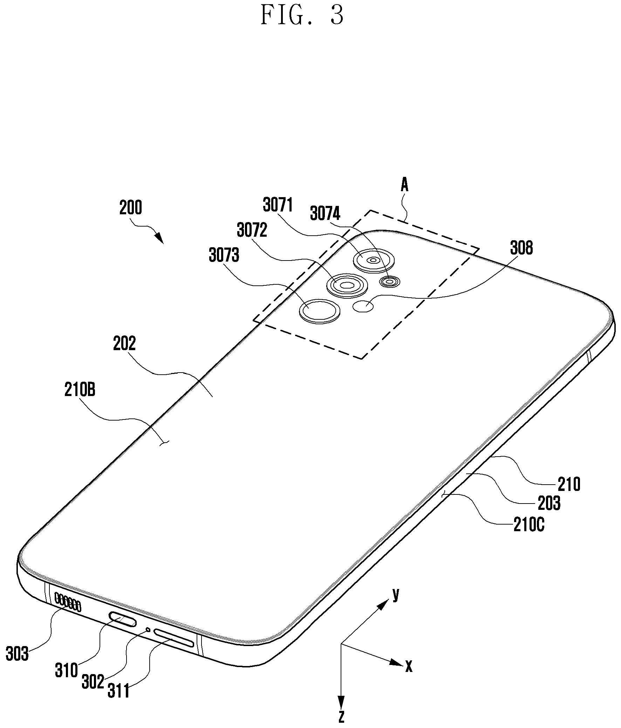

FIG. 2 is a front perspective view of an electronic device 200 according to an embodiment. FIG. 3 is a rear perspective view of the electronic device 200 according to an embodiment.

In various embodiments of this document, for convenience of explanation, a direction (e.g., +z-axis direction) in which a display 301 included in the electronic device 200 is visually exposed is defined as a front surface, and a direction opposite thereto (e.g., -z-axis direction) is defined as a rear surface.

Referring to FIGS. 2 and 3, the electronic device 200 (e.g., the electronic device 101 of FIG. 1) may include a housing 210. The housing 210 may provide, for example, a front surface 210A of the electronic device 200, a rear surface 210B of the electronic device 200, and a lateral surface 210C of the electronic device 200. In some embodiments, the housing 210 may refer to a structure including at least a part of the front surface 210A, the rear surface 210B, and the lateral surface 210C. In an embodiment, the housing 210 may include a front plate (or first plate) 201, a rear plate (or second plate) 202, and a lateral member (or lateral bezel structure) 203. The front surface 210A of the electronic device 200 may be provided by the front plate 201. The front plate 201 may be at least partially transparent and may include, for example, a glass plate including various coating layers, or a polymer plate. The rear surface 210B of the electronic device 200 may be provided by the rear plate 202. The rear plate 202 may be substantially opaque and may be formed of, for example, coated or colored glass, a ceramic, a polymer, a metal (e.g., aluminum, stainless steel (STS), or magnesium), or a combination of at least two of the above materials. The lateral member 203 may be coupled with the front plate 201 and the rear plate 202 and may form (or provide) the lateral surface 210C of the electronic device 200. The lateral member 203 may include a metal and/or a polymer.

According to an embodiment, the electronic device 200 may include at least one of the display 301, a first audio module 302, a second audio module 303, a third audio module 304, a sensor module 305, a front camera module 306, a plurality of rear camera modules (e.g., a first rear camera module 3071, a second rear camera module 3072, a third rear camera module 3073, and a fourth rear camera module 3074), a light-emitting module 308, an input module 309, a first connection terminal module 310, and a second connection terminal module 311. In some embodiments, the electronic device 200 may omit at least one of the above components or additionally include other components.

A display area (e.g., a screen display area or an active area) of the display 301 may be visually exposed through, for example, the front plate 201. In an embodiment, the electronic device 200 may be implemented so that the display area visible through the front plate 201 appears as large as possible (e.g., a large screen or a full screen). For example, the display 301 may be implemented to have an outer edge having substantially the same shape as an outer edge shape of the front plate 201. For another example, a distance between the outer edge of the display 301 and the outer edge of the front plate 201 may be formed to be substantially the same distance. **In** an embodiment, the display 301 may include a touch sensing circuit. **In** some embodiments, the display 301 may include a pressure sensor capable of measuring the intensity (pressure) of a touch. **In** some embodiments, the display 301 may be coupled to or positioned adjacent to a digitizer (e.g., an electromagnetic induction panel) configured to detect a magnetic field type electronic pen (e.g., a stylus pen). **In** some embodiments, the display 301 may be implemented to include a digitizer.

The first audio module 302 may include, for example, a microphone positioned inside the electronic device 200, and a microphone hole provided on the lateral surface 210C of the electronic device 200 to correspond to the microphone. The position or number of audio modules relating to the microphone is not limited to the illustrated example and may vary. For another example, the electronic device 200 may include a microphone hole configured on the rear surface 210B of the electronic device 200 and a microphone positioned inside the electronic device 200 to correspond to the microphone hole. **In** some embodiments, the electronic device 200 may include a plurality of microphones used to detect the direction of sound.

The second audio module 303 may include, for example, a first speaker positioned inside the electronic device 200, and a first speaker hole provided on the lateral surface 210C of the electronic device 200 to correspond to the first speaker. The third audio module 304 may include, for example, a second speaker positioned inside the electronic device 200, and a second speaker hole provided on the front surface 210A of the electronic device 200 to correspond to the second speaker. In an embodiment, the second speaker may include a receiver for phone calls, and the second speaker hole may be referred to as a receiver hole. The position or number of the second audio module 303 or the third audio module 304 is not limited to the illustrated example and may vary. In some embodiments, a microphone hole and a speaker hole may be implemented as one single hole. In some embodiments, the second audio module 303 or the third audio module 304 may include a piezo speaker without a speaker hole.

For example, the sensor module 305 may generate an electrical signal or a data value corresponding to an internal operating state of the electronic device 200 or an external environment state. **In** an embodiment, the sensor module 305 may include an optical sensor positioned inside the electronic device 200 to correspond to the front surface 210A of the electronic device 200. The optical sensor may include, for example, a proximity sensor or an illuminance sensor. The optical sensor may be aligned with an opening provided on the display 301. External light may reach the optical sensor through the opening of the display 301 and the front plate 201. **In** some embodiments, the optical sensor may be positioned on a rear surface of the display 301 or below or beneath the display 301, and may perform a related function without the position of the optical sensor being visually distinguished (or exposed). In some embodiments, the optical sensor may be aligned and positioned in a recess provided on the rear surface of the display 301. The optical sensor may be disposed to overlap at least a part of a screen (or a display area) and perform its sensing function without being visually exposed. In this case, a partial area of the display 301 that at least partially overlaps the optical sensor may include a different pixel structure and/or wiring structure compared to other areas. For example, a partial area of the display 301 that at least partially overlaps the optical sensor may have a different pixel density compared to other areas. In some embodiments, a plurality of pixels may not be arranged in a partial area of the display 301 that at least partially overlaps the optical sensor. In some embodiments, the electronic device 200 may include a biometric sensor (e.g., a fingerprint sensor) positioned on the rear surface of the display 301 or below or beneath the display 301. The biometric sensor may be implemented as an optical sensor, an electrostatic sensor, or an ultrasonic sensor, and the position or number thereof may vary. The electronic device 200 may further include at least one of various other sensor modules such as a gesture sensor, a gyro sensor, a barometric pressure sensor, a magnetic sensor, an acceleration sensor, a grip sensor, a color sensor, an infrared (IR) sensor, a temperature sensor, or a humidity sensor.

For example, the front camera module 306 may be positioned inside the electronic device 200 to correspond to the front surface 210A of the electronic device 200. For example, the plurality of rear camera modules 3071, 3072, 3073, and 3074 may be positioned inside the electronic device 200 to correspond to the rear surface 210B of the electronic device 200. The front camera module 306 and/or the rear camera module 3071, 3072, 3073, or 3074 may include one or more lenses, an image sensor, and/or an image signal processor. The position or number of camera modules is not limited to the illustrated example and may vary.

According to an embodiment, the display 301 may include an opening aligned with the front camera module 306. External light may reach the front camera module 306 through the opening of the display 301 and the front plate 201. The opening of the display 301 aligned with or overlapping the front camera module 306 may be provided in the form of a notch. In some embodiments, the opening of the display 301 aligned with or overlapping the front camera module 306 may be provided in the form of a hole. In some embodiments, the front camera module 306 may be positioned on the rear surface of the display 301 or below or beneath the display 301, and the position of the front camera module 306 may perform a related function (e.g., image capturing) without the position of the front camera module 306 being visually distinguished (or exposed). The front camera module 306 may include, for example, a hidden display rear camera (e.g., an under display camera (UDC)). In some embodiments, the front camera module 306 may be aligned and positioned in a recess provided on the rear surface of the display 301. The front camera module 306 may be disposed to overlap at least a part of a screen (or a display area), so as to obtain an image of an external subject without being visually exposed to the outside. In this case, a partial area of the display 301 that at least partially overlaps the front camera module 306 may include a different pixel structure and/or wiring structure compared to other areas. For example, a partial area of the display 301 that at least partially overlaps the front camera module 306 may have a different pixel density compared to other areas. The pixel structure and/or wiring structure disposed in a partial area of the display 301 that at least partially overlaps the front camera module 306 may reduce light loss between the outside and the front camera module 306. In some embodiments, a pixel may not be disposed in a partial area of the display 301 that at least partially overlaps the front camera module 306. In some embodiments, the electronic device 200 may further include a light-emitting module (e.g., a light source) positioned inside the electronic device 200 to correspond to the front surface 210A of the electronic device 200. For example, the light-emitting module may provide state information of the electronic device 200 in the form of light. In some embodiments, the light-emitting module may provide a light source linked to an operation of the front camera module 306. The light-emitting module may include, for example, an LED, an IR LED, or a xenon lamp.

According to an embodiment, the rear plate 202 may include, when viewed from above the rear plate 202 (e.g., when viewed in the +z axis direction), a plurality of openings which correspond one-to-one with the plurality of rear camera modules 3071, 3072, 3073, and 3074. The plurality of rear camera modules 3071, 3072, 3073, and 3074 may be positioned through the plurality of openings of the rear plate 202. In some embodiments, the rear plate 202 may be implemented to include substantially transparent light-transmitting areas, replacing the plurality of openings corresponding to the plurality of rear camera modules 3071, 3072, 3073, and 3074. In an embodiment, the plurality of rear camera modules 3071, 3072, 3073, and 3074 may have different properties (e.g., an angle of view) or functions and may include, for example, a dual camera or a triple camera. The plurality of rear camera modules 3071, 3072, 3073, and 3074 may include a plurality of camera modules including lenses having different angles of view, and the electronic device 200 may be implemented to change an angle of view of a camera module performed by the electronic device 200, based on a user's selection. The plurality of rear camera modules 3071, 3072, 3073, and 3074 may include at least one of a wide-angle camera, a telephoto camera, a color camera, a monochrome camera, or an infrared (IR) camera (e.g., a time of flight (TOF) camera or a structured light camera). In some embodiments, the IR camera may operate as at least a part of a sensor module.

According to an embodiment, the rear plate 202 may include an opening corresponding to the light-emitting module 308 when viewed from above the rear plate 202. The light-emitting module 308 may be positioned through the opening of the rear plate 202. In some embodiments, the rear plate 202 may be implemented to include substantially transparent light-transmitting areas, replacing the opening corresponding to the light-emitting module 308. The light-emitting module 308 may include a light source (e.g., a flash) for the plurality of rear camera modules 3071, 3072, 3073, and 3074. The light-emitting module 308 may include, for example, an LED or a xenon lamp.

The input module 309 may include, for example, one or more key input devices. For example, the one or more key input devices may be positioned in an opening provided on the lateral surface 210C of the electronic device 200. In some embodiments, the electronic device 200 may not include some or all of the key input devices, and a key input device not included may be implemented as a soft key by using the display 301. The position or number of the input module 309 may vary, and in some embodiments, the input module 309 may include at least one sensor module.

The first connection terminal module (e.g., a first connector module or a first interface terminal module) 310 may include, for example, a first connector (or a first interface terminal) positioned inside the electronic device 200, and a first connector hole provided on the lateral surface 210C of the electronic device 200 to correspond to the first connector. The electronic device 200 may transmit and/or receive power and/or data to and/or from an external electronic device electrically connected to the first connector. In an embodiment, the first connector may include a universal serial bus (USB) connector or a high definition multimedia interface (HDMI) connector. In some embodiments, the electronic device 200 may further include another connection terminal module including an audio connector (e.g., a headphone connector or an earset connector). The second connection terminal module (e.g., a second connector module or a second interface terminal module) 311 may be used to mount an external storage medium (e.g., a SIM card or a memory card) to the electronic device 200. The second connection terminal module 311 may include, for example, a second connector (or a second interface terminal) positioned inside the electronic device 200, and a second connector hole provided on the lateral surface 210C of the electronic device 200 to correspond to the second connector. The second connection terminal module 311 may include a cover which is positioned (e.g., fitted into) in the second connector hole and forms a part of the lateral surface 210C of the electronic device 200. In an embodiment, the second connection terminal module 311 may include a tray (or an adapter) (e.g., a SIM tray) for electrically or mechanically connecting an external storage medium to the second connector. The external storage medium may be disposed on the tray to be inserted into the second connector hole, and the external storage medium may be electrically connected to the second connector. In some embodiments, the tray may be connected to a cover. The position or number of connection terminal modules is not limited to the illustrated example and may vary.

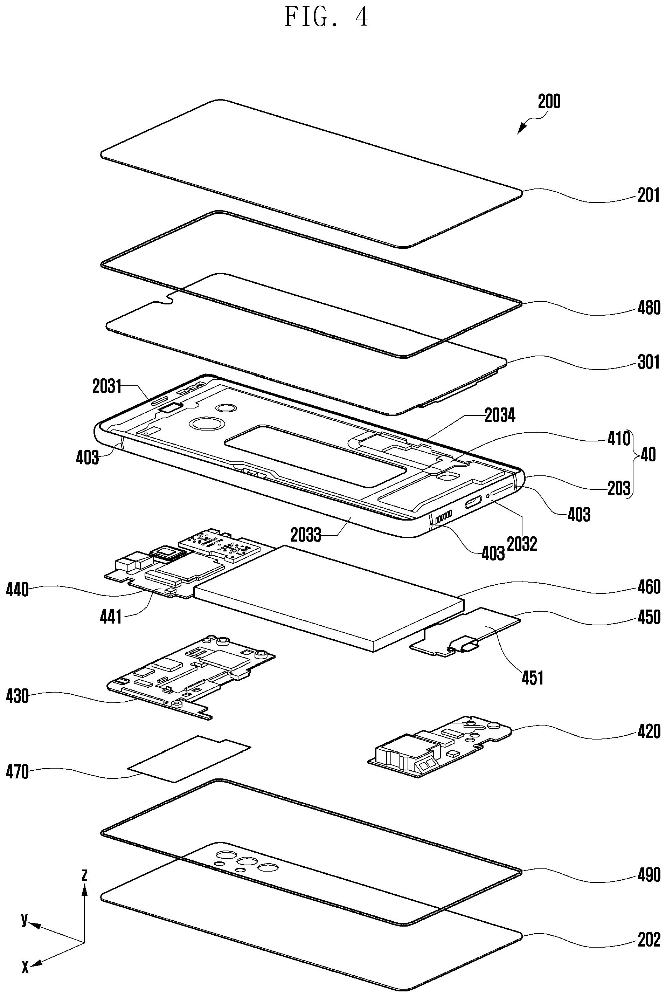

FIG. 4 is an exploded perspective view of the electronic device 200 according to an embodiment.

Referring to FIG. 4, in an embodiment, the electronic device 200 may include the front plate 201, the rear plate 202, the lateral member 203, a first support member 410, a second support member 420, a third support member 430, the display 301, a first board assembly 440, a second board assembly 450, a battery 460, an antenna structure 470, a first adhesive member 480, and/or a second adhesive member 490. In some embodiments, the electronic device 200 may omit some of the above components or additionally include other components.

According to an embodiment, the lateral member 203 may include a first lateral portion (or first bezel portion) 2031, a second lateral portion (or second bezel portion) 2032, a third lateral portion (or third bezel portion) 2033, and/or a fourth lateral portion (or fourth bezel portion) 2034. When viewed from above the front plate 201 (e.g., when viewed in the -z-axis direction), the first lateral portion 2031 and the second lateral portion 2032 may be positioned to be spaced apart from each other in a first direction (e.g., y-axis direction) and may be substantially parallel to each other. The first lateral portion 2031 may provide a first lateral surface corresponding to the +y-axis direction of the electronic device 200 of the lateral surface 210C, and the second lateral portion 2032 may provide a second lateral surface corresponding to the -y-axis direction of the electronic device 200 of the lateral surface 210C. The third lateral portion 2033 may connect one end portion of the first lateral portion 2031 and one end portion of the second lateral portion 2032. The fourth lateral portion 2034 may connect the other end portion of the first lateral portion 2031 and the other end portion of the second lateral portion 2032. When viewed from above the front plate 201, the third lateral portion 2033 and the fourth lateral portion 2034 may be positioned to be spaced apart from each other in a second direction (e.g., x-axis direction) perpendicular to the first direction and may be substantially parallel to each other. The third lateral portion 2033 may provide a third lateral surface corresponding to the +x-axis direction of the electronic device 200 of the lateral surface 210C, and the fourth lateral portion 2034 may provide a fourth lateral surface corresponding to the - x-axis direction of the electronic device 200 of the lateral surface 210C. A corner where the first lateral portion 2031 and the third lateral portion 2033 are connected, a corner where the first lateral portion 2031 and the fourth lateral portion 2034 are connected, a corner where the second lateral portion 2032 and the third lateral portion 2033 are connected, and/or a corner where the second lateral portion 2032 and the fourth lateral portion 2034 are connected may be implemented to have a smooth curved shape.

According to an embodiment, the lateral member 203 may include a plurality of insulating portions 403 and a plurality of conductive portions separated from each other by the plurality of insulating portions 403. The lateral surface 210C (referring to FIG. 2) of the electronic device 200 may be provided by the plurality of conductive portions and the plurality of insulating portions 403. The lateral surface 210C may include first areas provided by the plurality of conductive portions included in the lateral member 203. The lateral surface 210C may include second areas provided by the plurality of insulating portions 403 included in the lateral member 203. The first areas and second areas of the lateral surface 210C may be smoothly connected without a substantial difference in height. In various embodiments, the plurality of conductive portions included in the lateral member 203 or disposed on the lateral member 203 may be electrically connected to a communication circuit (e.g., the wireless communication module 192 of FIG. 1) included in the first board assembly 440 or the second board assembly 450, and operate as an antenna radiator.

According to an embodiment, the first support member 410 may be positioned inside the electronic device 200 and connected to the lateral member 203, or may be configured integrally with the lateral member 203. The first support member 410 may be formed of, for example, a metal material and/or a non-metal material (e.g., polymer).

According to an embodiment, an element including the first support member 410 and the lateral member 203 may be referred to as a front case 40. Electronic components, such as the display 301, the first board assembly 440, the second board assembly 450, or the battery 460, or various members associated with the electronic components may be disposed on the front case 40 or the first support member 410, or supported by the front case 40 or the first support member 410. The front case 40 or the first support member 410 may be included in the electronic device 200 so as to withstand a load, and thus contribute to the durability or rigidity (e.g., torsional rigidity) of the electronic device 200. In some embodiments, the front case 40 or the first support member 410 may be referred to by various other terms such as a "first frame", a "first frame structure", or a "first framework". The first support member 410 is an internal structure located in the internal space of the electronic device 200. In some embodiments, the first support member may be referred to by various other terms such as a "bracket", a "first support", or a "first support structure". In some embodiments, the first support member 410 may be interpreted as a part of the housing 210 (referring to FIG. 2). In various embodiments, the front case 40 may have a metal material and a polymer material, and a polymer or polymer composite material is insert-injected into a metal part formed from a metal material, so that the front case may be formed so that the metal material and the polymer material are bonded to each other.

According to an embodiment, at least one conductive part included in the first support member 410 may serve as electromagnetic shielding and/or a ground for the display 301, the first board assembly 440, and/or the second board assembly 450.

For example, the display 301 may be positioned between the first support member 410 and the front plate 201, and may be disposed on a surface of the first support member 410 facing the front plate 201. In an embodiment, the display 301 may be coupled to the front plate 201 by using an optical transparent adhesive member such as optical clear resin (OCA), optical clear resin (OCR), or super view resin (SVR). For example, the first board assembly 440 and the second board assembly 450 may be positioned between the first support member 410 and the rear plate 202, and may be disposed on a surface of the first support member 410 facing the rear plate 202. For example, the battery 460 may be positioned between the first support member 410 and the rear plate 202, and may be disposed in the first support member 410.

According to an embodiment, the first board assembly 440 may include a first printed circuit board 441 (e.g., a printed circuit board (PCB) or a printed circuit board assembly (PBA)). The first board assembly 440 may include various electronic components electrically connected to the first printed circuit board 441. The electronic components may be disposed on the first printed circuit board 441 or may be electrically connected to the first printed circuit board 441 through an electrical path such as a cable or a flexible printed circuit board (FPCB). Referring to FIGS. 2 and 3, the electronic components may include, for example, a second speaker included in the third audio module 304, the sensor module 305, the front camera module 306, the plurality of rear camera modules 3071, 3072, 3073, and 3074, the light-emitting module 308, or the input module 309.

According to an embodiment, when viewed from above the front plate 201 (e.g., when viewed in the -z-axis direction), the second board assembly 450 may be disposed to be spaced apart from the first board assembly 440 with the battery 460 interposed therebetween. The second board assembly 450 may include a second printed circuit board 451 electrically connected to the first printed circuit board 441 of the first board assembly 440. The second board assembly 450 may include various electronic components electrically connected to the second printed circuit board 451. The electronic components may be disposed on the second printed circuit board 451 or may be electrically connected to the second printed circuit board 451 through an electrical path such as a cable or an FPCB. Referring to FIGS. 2 and 3, the electronic components may include, for example, a microphone included in the first audio module 302, a first speaker included in the second audio module 303, a first connector included in the first connection terminal module 310, or a second connector included in the second connection terminal module 311.

According to some embodiments, the first board assembly 440 or the second board assembly 450 may include a primary PCB (or main PCB or master PCB), a secondary PCB (or slave PCB) disposed to partially overlap the primary PCB, and/or an interposer substrate between the primary PCB and the secondary PCB.

The battery 460 is a device for supplying power to at least one component of the electronic device 200 and may include, for example, a non-rechargeable primary cell, a rechargeable secondary cell, or a fuel cell. The battery 460 may be integrally disposed inside the electronic device 200. In some embodiments, the battery 460 may be attached to or detached from the electronic device 200.

According to an embodiment, the third support member 430 may be positioned between the first support member 410 and the rear plate 202, and coupled to the first support member 410 and/or the first board assembly 440 by using a fastening element such as a screw (or bolt). At least a part of the first board assembly 440 may be positioned between the first support member 410 and the third support member 430, and the third support member 430 may cover and protect the first board assembly 440. When viewed from above the rear plate 202 (e.g., when viewed in the +z-axis direction), the second support member 420 may be positioned to be at least partially spaced apart from the third support member 430 with the battery 460 interposed therebetween. The second support member 420 may be positioned between the first support member 410 and the rear plate 202, and coupled to the first support member 410 and/or the second board assembly 450 by using a fastening element such as a screw (or bolt). At least a part of the second board assembly 450 may be positioned between the first support member 410 and the second support member 420, and the second support member 420 may cover and protect the second board assembly 450. The second support member 420 and/or the third support member 430 may be formed of a metal material and/or a non-metal material (e.g., polymer). In some embodiments, the third support member 430 may serve as electromagnetic shielding for the first board assembly 440, and the second support member 420 may serve as electromagnetic shielding for the second board assembly 450. In some embodiments, the second support member 420 and/or the third support member 430 may be referred to as a "rear case". In some embodiments, the second support member 420 may be referred to by various other terms such as a "second support" or a "second support structure", and the third support member 430 may be referred to by various other terms such as a "third support" or a "third support structure". In some embodiments, the second support member 420 and/or the third support member 430 may be interpreted as a part of the housing 210 (referring to FIG. 2).

According to an embodiment, at least one conductive portion included in the second support member 420 or disposed in the second support member 420 may operate as an antenna radiator electrically connected to a communication circuit (e.g., the wireless communication module 192 of FIG. 1) included in the first board assembly 440 or the second board assembly 450.

According to an embodiment, at least one conductive portion included in the third support member 430 or disposed in the third support member 430 may operate as an antenna radiator electrically connected to a communication circuit (e.g., the wireless communication module 192 of FIG. 1) included in the first board assembly 440 or the second board assembly 450.

According to some embodiments, an integrated board assembly including the first board assembly 440 and the second board assembly 450 may be implemented. For example, when viewed from above the rear plate 202 (e.g., when viewed in the +z-axis direction), the board assembly may include a first part and a second part positioned to be spaced apart from each other with the battery 460 interposed therebetween, and a third part extending between the battery 460 and the lateral member 203 and connecting the first part and the second part. The third part may be substantially rigidly implemented. In some embodiments, the third part may be implemented to be substantially flexible. In some embodiments, an integrated support member including the second support member 420 and the third support member 430 may be implemented.

According to an embodiment, the antenna structure 470 may be positioned between the third support member 430 and the rear plate 202. In some embodiments, the antenna structure 470 may be positioned between the battery 460 and the rear plate 202. The position of the antenna structure 470 is not limited thereto and may vary. For example, the antenna structure 470 may be implemented in a film form such as an FPCB. The antenna structure 470 may include at least one conductive pattern used as a loop-type radiator. For example, the at least one conductive pattern may include a planar-shaped spiral conductive pattern (e.g., a planar coil or a pattern coil). In an embodiment, the at least one conductive pattern included in the antenna structure 470 may be electrically connected to a communication circuit (or a wireless communication circuit) (e.g., the wireless communication module 192 of FIG. 1) included in the first board assembly 440. For example, the at least one conductive pattern may be used in short-range wireless communication such as near field communication (NFC). As another example, the at least one conductive pattern may be used in magnetic secure transmission (MST) for transmitting and/or receiving a magnetic signal. In some embodiments, the at least one conductive pattern included in the antenna structure 470 may be electrically connected to a power transmission/reception circuit included in the first board assembly 440. The power transmission/reception circuit may wirelessly receive power from an external electronic device or wirelessly transmit power to an external electronic device by using the at least one conductive pattern. The power transmission/reception circuit may include a power management module, and may include, for example, a power management integrated circuit (PMIC) or a charger integrated circuit (IC). The power transmission/reception circuit may charge the battery 460 by using power received wirelessly using a conductive pattern.

According to some embodiments, a processor (e.g., the processor 120 of FIG. 1) electrically connected to a wireless communication circuit (e.g., the wireless communication module 192 of FIG. 1) may use the antenna structure 470 to perform a position determination function (e.g., an angle of arrival (AOA)) for a signal source (e.g., a responder, a transmitter, or a transmitter (Tx) device). The processor may simultaneously perform position determination (AOA) which measures an angle, and position determination (ranging) which measures a distance. In an embodiment, the processor may identify (or estimate) a distance between the electronic device 200 and the signal source by using at least one antenna element (e.g., a first antenna element, a second antenna element, and/or a third antenna element) included in the antenna structure 470. In an embodiment, the processor may identify or estimate a reception angle of a signal (e.g., a direction of the signal) with respect to a set axis of the electronic device 200 by using at least one of a difference in an arrival time of a response message to a request message, a difference in an arrival distance between received signals, or a phase difference through at least two antenna elements included in the antenna structure 470. The electronic device 200 may support a position determination function by using a broadband bandwidth (e.g., ultra-wide band (UWB)). For example, the UWB is a technology that follows the international standard of IEEE 802.15.4 and may refer to a technology which performs communication with a broadband bandwidth. In an embodiment, the processor may identify or estimate a position of a signal source (e.g., a responder, a transmitter, or a Tx device) with respect to the electronic device 200 (e.g., an initiator, a receiver, or a receiver (Rx) device) by using a phase difference of signals received through a plurality of antenna elements included in the antenna structure 470. The antenna structure 470 may be implemented as a printed circuit board (e.g., a flexible printed circuit board (FPCB)), and may be, for example, a patch antenna including a plurality of patches (e.g., a first antenna element, a second antenna element, and a third antenna element).

According to an embodiment, the first adhesive member 480 may be positioned between the front plate 201 and the first support member 410, or between the front plate 201 and the lateral member 203. The front plate 201 may be coupled to the first support member 410 or the lateral member 203 by using the first adhesive member 480. For example, the first adhesive member 480 may be disposed in an annular shape adjacent to the edge (or border) of the front plate 201. The first adhesive member 480 may be disposed in various other forms which are not limited to the illustrated example. In some embodiments, the first adhesive member 480 may include a plurality of adhesive members separated from each other. In this case, there may be a separate adhesive member or filling member which connects two adhesive members separated from each other.

According to an embodiment, the second adhesive member 490 may be positioned between the rear plate 202 and the first support member 410, or between the rear plate 202 and the lateral member 203. The rear plate 202 may be coupled to the first support member 410 or the lateral member 203 by using the second adhesive member 490. For example, the second adhesive member 490 may be disposed in an annular shape adjacent to the edge (or border) of the rear plate 202. The second adhesive member 490 may be disposed in various other forms which are not limited to the illustrated example. In some embodiments, the second adhesive member 490 may include a plurality of adhesive members separated from each other. In this case, there may be a separate adhesive member or filling member which connects two adhesive members separated from each other.

According to an embodiment, the first adhesive member 480 or the second adhesive member 490 may include a heat-reactive adhesive material, a photo-reactive adhesive material, a general adhesive, or a double-sided tape.

The electronic device 100 or 200 according to various embodiments may include an electronic device such as a bar type, a foldable type, a rollable type, a sliding type, a wearable type, a tablet PC, and/or a laptop PC. The electronic device 100 or 200 according to various embodiments of the disclosure is not limited to the examples described above and may include various other electronic devices.

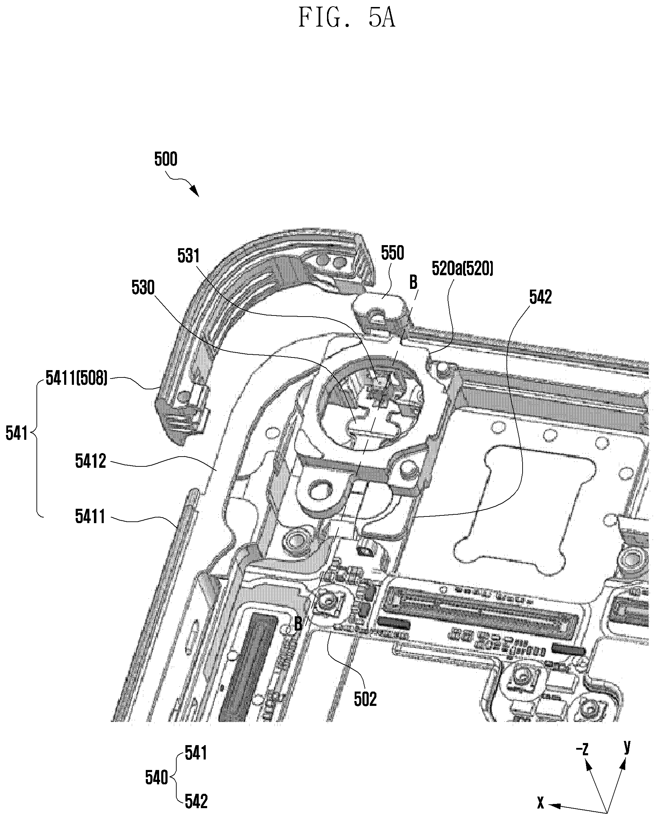

FIG. 5A is an exploded perspective view of a part of an electronic device 500 according to various embodiments.

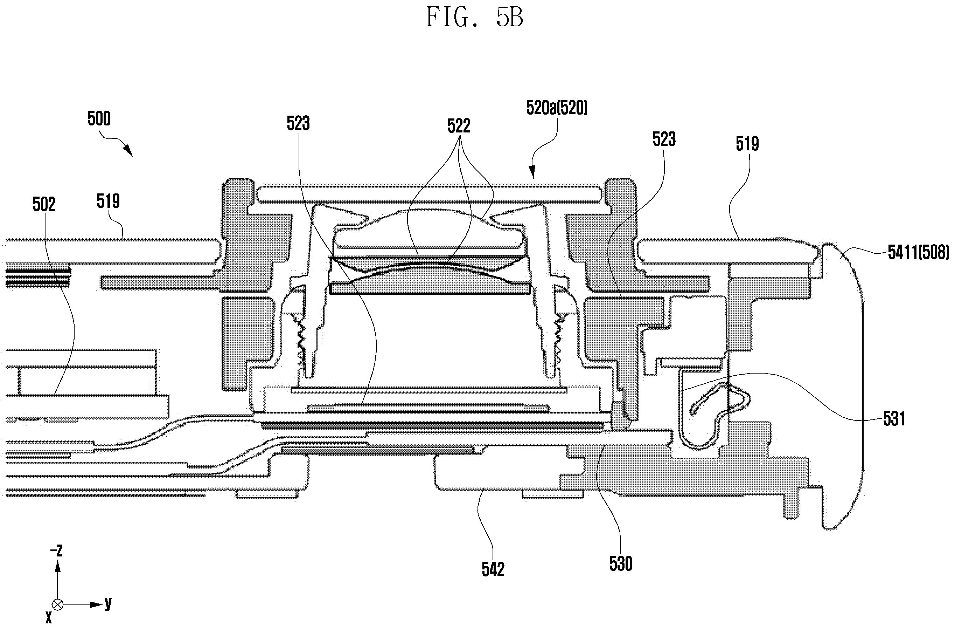

FIG. 5B is a cross-sectional view of the electronic device 500 according to various embodiments.

FIG. 5A is an exploded perspective view of part A in FIG. 3.

FIG. 5B is a cross-sectional view taken along the B-B direction of FIG. 5A.

Referring to FIGS. 5A and 5B, the electronic device 500 may include a housing 510 (e.g., the housing 210 of FIGS. 2 to 4), at least one printed circuit board 502 (e.g., the first board assembly 440 and/or the second board assembly 450 of FIG. 4), an electrical component, and a flexible printed circuit board 530. The housing 510 may be a part which provides an internal space for arrangement of components of the electronic device 500 and protects the components of the electronic device 500. The housing 510 may include a frame 540 (e.g., the front case 40 of FIG. 4), a front plate 518 (e.g., the front plate 201 of FIGS. 2 to 4), and a rear plate 519 (e.g., the rear plate 202 of FIGS. 2 to 4). The frame 540 may include a lateral frame 541 (e.g., the lateral member 203 of FIG. 4) which protects a lateral surface (e.g., surfaces facing x and y directions) of the electronic device 500, and a support member 542 (e.g., the first support member 410 of FIG. 4) extending from the lateral frame 541 into the internal space of the electronic device 500. The lateral frame 541 may include a plurality of metal segments 5411 and a polymer inj ection portion 5412 configured to couple the plurality of metal segments 5411. The support member 542 may be a part which extends from the lateral frame 541 and supports internal components of the electronic device 500. The support member 542 may include a polymer part and a metal part.

The printed circuit board 502 may be a circuit board on which various electrical components of the electronic device 500 are arranged or electrically connected. In various embodiments, a wireless communication module (e.g., the wireless communication module 192 of FIG. 1) may be disposed on the printed circuit board 502.

In various embodiments, the electronic device 500 includes at least one antenna 508. The antenna 508 may be integrated with the housing 510 of the electronic device 500 to save or conserve the internal space of the electronic device 500 and improve the design of the electronic device 500. For example, at least one of the plurality of metal segments 5411 of the lateral frame 541 may serve as the antenna 508. To this end, the metal segment 5411 serving as the antenna 508 may be electrically connected to the communication module.

In various embodiments, the electronic device 500 includes the flexible printed circuit board 530. The flexible printed circuit board 530 may include a flexible substrate and a conductor pattern attached to a surface of the substrate. The flexible printed circuit board 530 may be referred to as a flexible printed cable. In various embodiments, the flexible printed circuit board 530 may electrically connect the antenna 508 (that is, the metal segment 5411 of the lateral frame 541) with the printed circuit board 502 and/or the wireless communication module. Since the flexible printed circuit board 530 is more flexible and thinner than the printed circuit board 502, the internal space of the electronic device 500 may be saved compared to a situation where the printed circuit board 502 is extended to the antenna 508 in order to connect the wireless communication circuit and the antenna 508.

The electronic device 500 includes various electrical components 520 such as a camera 520a. The camera 520a may include a camera housing 521, at least one optical element 522, and an image sensor.

In various embodiments, the flexible printed circuit board 530 may extend along one surface of an electrical component 520. In various embodiments, one surface of the electrical component 520 may face the support member 542, and the flexible printed circuit board 530 may extend between the one surface of the electrical component and the support member 542.

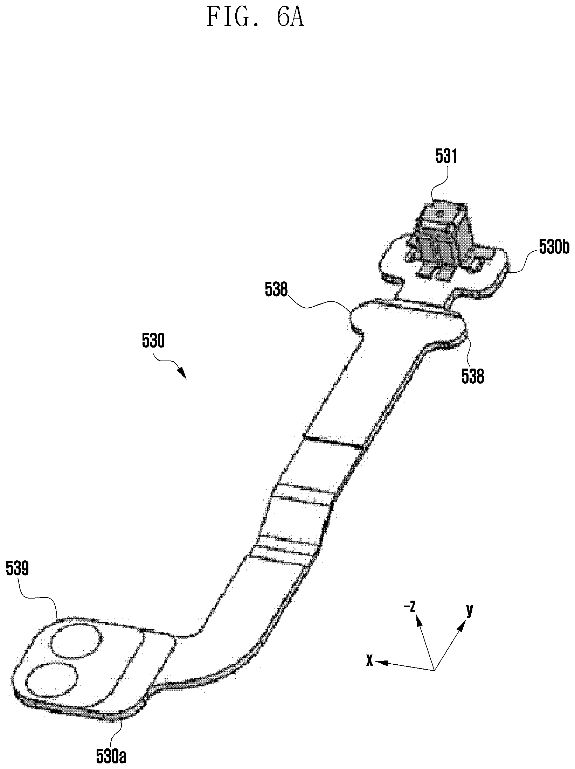

In various embodiments, first end portion 530a (shown in Figure 6A) of the flexible printed circuit board 530 may be connected to the printed circuit board 502, and a contact member 531 may be disposed in a second end portion 530b (shown in Figure 6A) of the flexible printed circuit board. The contact member 531 may include a metal material (e.g., copper, iron, stainless steel, brass, and/or aluminum alloy). The contact member 531 may be a part which forms an electrical contact with the metal segment 5411 (that is, the antenna 508) of the lateral frame 541. In various embodiments, the electronic device 500 may include a fixing member 550 positioned on the second end portion 530b of the flexible printed circuit board 530. The contact member 531 and the fixing member 550 will be described in more detail later.

FIG. 6A is a perspective view showing the flexible printed circuit board 530 according to various embodiments.

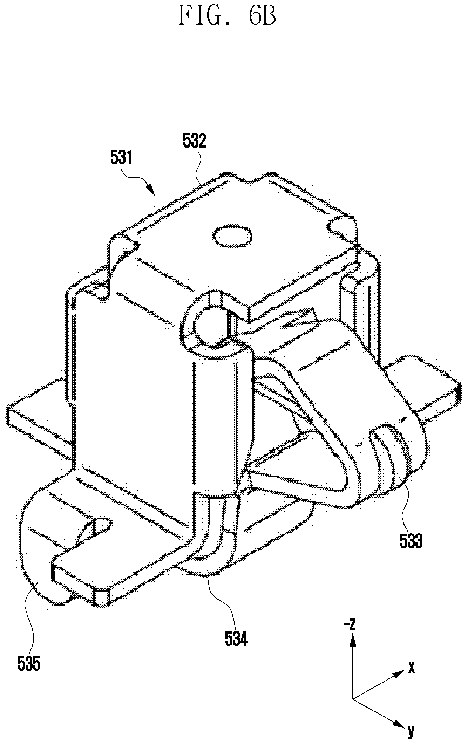

FIG. 6B is a perspective view showing the contact member 531 according to various embodiments.

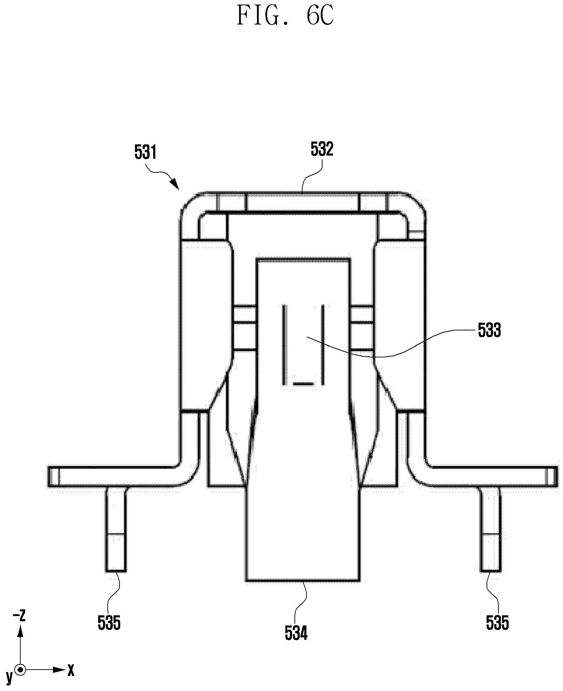

FIG. 6C is a front view showing the contact member 531 according to various embodiments.

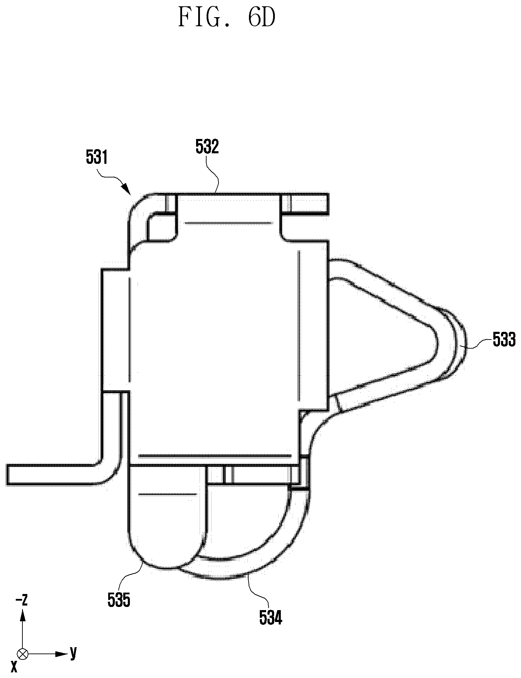

FIG. 6D is a side view showing the contact member 531 according to various embodiments.

Referring to FIG. 6A, in the flexible printed circuit board 530 according to various embodiments, a connector 539 may be disposed at first end portion 530a and the contact member 531 may be disposed at the second end portion 530b. The connector 539 may be a member configured to be connected to the printed circuit board 502 (and a wireless communication module disposed on the printed circuit board 502) of the electronic device 500. For example, the connector 539 may be configured to be inserted and fixed into a socket disposed on the printed circuit board 502. The contact member 531 may be a member which forms electrical contact with the antenna 508 by applying an elastic force to a surface or portion of the antenna 508.

In various embodiments, a protrusion portion 538 formed by increasing a width (e.g., a dimension in the x-axis direction) of a section of the flexible printed circuit board 530 may be configured in an area adjacent to the second end portion 530b of the flexible printed circuit board 530. That is, a protrusion portion 538 may be provided in an area of the flexible printed circuit board 530 which is close to, near, or within a predetermined distance of the second end portion 530b of the flexible printed circuit board. The protrusion portion 538 may be provided in an area of the flexible printed circuit board which is at a predetermined distance from an end of the second end portion 530b. The protrusion portion 538 may be provided in an area of the flexible printed circuit board which is at a predetermined distance from the contact member 531. The protrusion portion 538 may be an area of the flexible printed circuit board which has a width greater than the width of a majority of the flexible printed circuit board 530. The protrusion portion 538 may be an area of the flexible printed circuit board with a width which is greater than a width of an adjacent area or region of the flexible printed circuit board 530. The protrusion portion 538 may have a width of at least 10%, 20%, 25%, 33% or 50% more than the width of an adjacent area of the flexible printed circuit board. The protrusion portion 538 may appear as a bulge in the width of the flexible printed circuit board. The extra width of the protrusion portion 538 may extend equally or substantially equally from either side of flexible printed circuit board such that the protrusion portion 538 is substantially symmetric with respect to an adjacent portion of the flexible printed circuit board 530. The width of the portions of the flexible printed circuit board 530 adjacent to and on either side of the protrusion portion 538 may be the same or substantially the same. The protrusion portion 538 may be a part which restricts the movement of the flexible printed circuit board 530 caused by the elastic force applied by the contact member 531. The action of the protrusion portion 538 will be described in more detail later.

Referring to FIGS. 6B to 6D, the contact member 531 according to various embodiments may include a main body portion 532, a contact point 533, a clip 534, and a lead 535. The contact point 533 may be a part which is in contact with another electrical component 520 (e.g., the antenna 508) to form an electrical contact. The clip 534 may be a member which is configured to generate an elastic force through a spring action, and to apply an elastic force so that the contact point 533 is in contact with the another electrical component. The lead 535 may be a member which is fixed to the flexible printed circuit board 530 by means such as solder and formed to form an electrical connection. The main body portion 532 may be a member which partially covers a component such as the clip 534. Main body portion 532 may be fixed to fixing member 550, such that the contact member 531 is fixed to the may be fixed to the frame 540

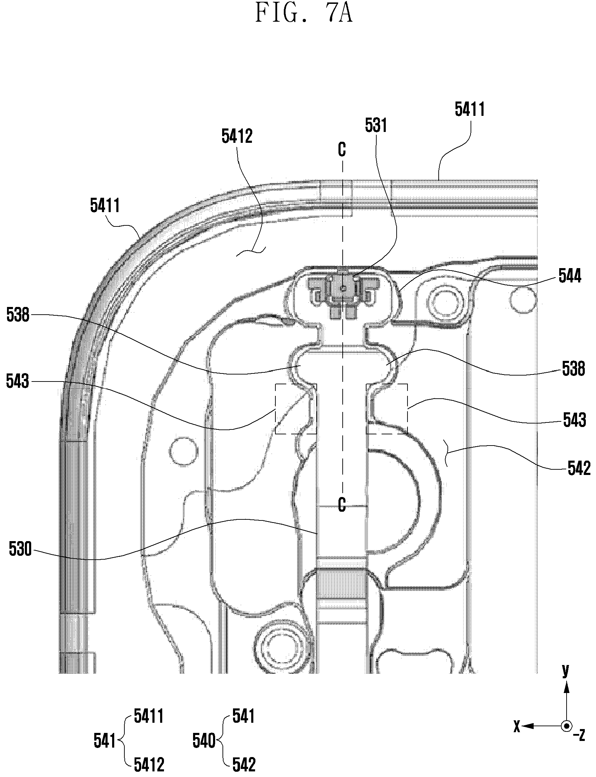

FIG. 7A is a plan view showing the frame 540 and the flexible printed circuit board 530 according to various embodiments of the disclosure.

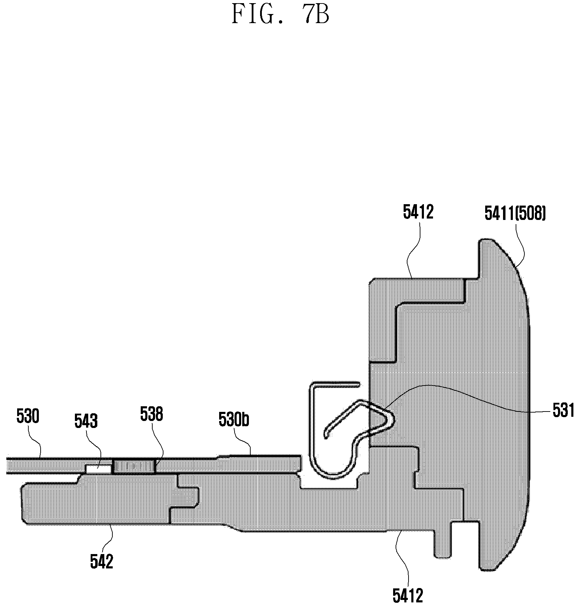

FIG. 7B is a cross-sectional view showing the frame 540 and the flexible printed circuit board 530 according to various embodiments of the disclosure.

FIG. 7B is a cross-sectional view taken along the C-C direction of FIG. 7A.

According to FIGS. 7A and 7B, the support member 542 of the frame 540 may include a catching protrusion 543 configured at a part of the support member 542 corresponding to the protrusion portion 538 of the flexible printed circuit board 530. For example, a surface of the support member 542 overlapping the protrusion portion 538 of the flexible printed circuit board 530 is recessed in the z direction, or a peripheral part of an area overlapping the protrusion portion 538 protrudes in the -z direction, so that the catching protrusion 543 may be formed.

Since the contact member 531 applies an elastic force to the antenna 508, due to reaction (Newton's third law), a reaction or reactive force (F) is applied to the flexible printed circuit board 530, which may move the flexible printed circuit board 530 in a direction away from the antenna 508. This causes the contact member 531 on the flexible printed circuit board 530 to move away from the antenna 508, so the electric connection between the contact member 531 and the antenna 508 is weakened. Therefore, the elastic force applied by the contact member 531 to the antenna 508 to form electrical contact is weakened, and thus the electrical contact between the contact member 531 and the antenna 508 may become unstable or the contact resistance may increase. Therefore, the quality of a signal transmitted or received through the antenna 508 may deteriorate. According to various embodiments of the disclosure, since the protrusion portion 538 of the flexible printed circuit board 530 is caught by the catching protrusion 543 and thus the movement of the flexible printed circuit board 530 is restricted, the contact member 531 may form electrical contact with the antenna 508 by a sufficiently strong elastic force, and thus, the quality of a signal transmitted or received through the antenna 508 may be improved. That is, the catching protrusion 543 of the support member 542 catches or interacts with the protrusion portion 538 of the flexible printed circuit board 530 to prevent or reduce the movement of the flexible printed circuit board 530 away from the antenna 508 by the reactive force F. The contact member 531 therefore maintains a good contact with the antenna 508, so the quality of signal transmitted or received through the antenna 508 may be improved.

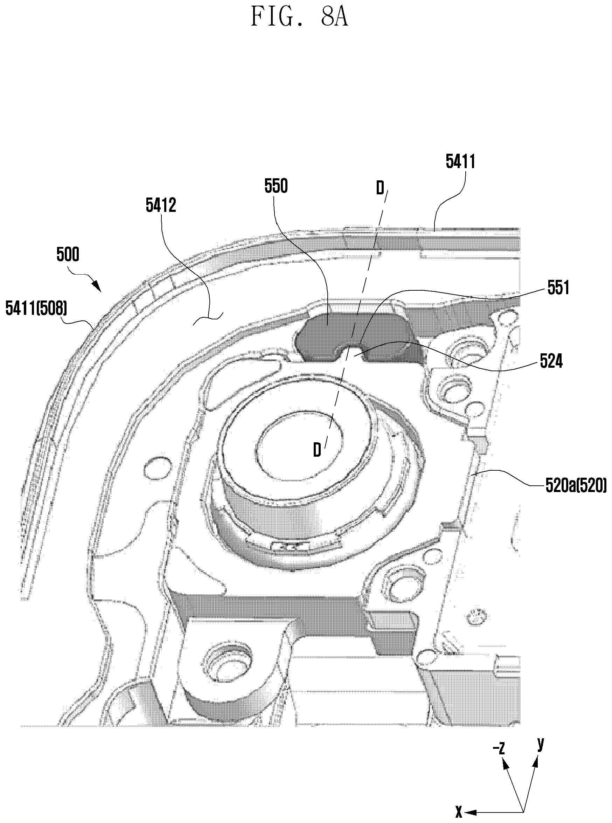

FIG. 8A is a perspective view of the electronic device 500 according to various embodiments.

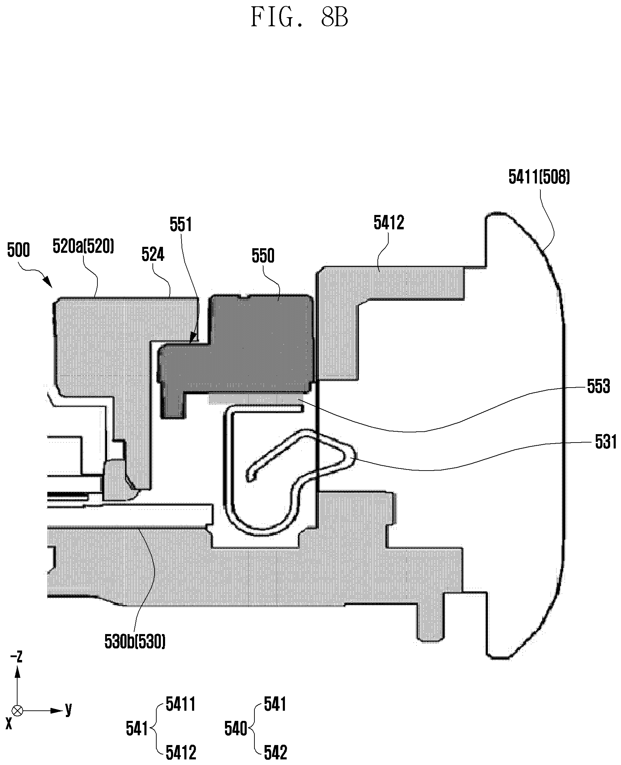

FIG. 8B is a cross-sectional view of the electronic device 500 according to various embodiments.

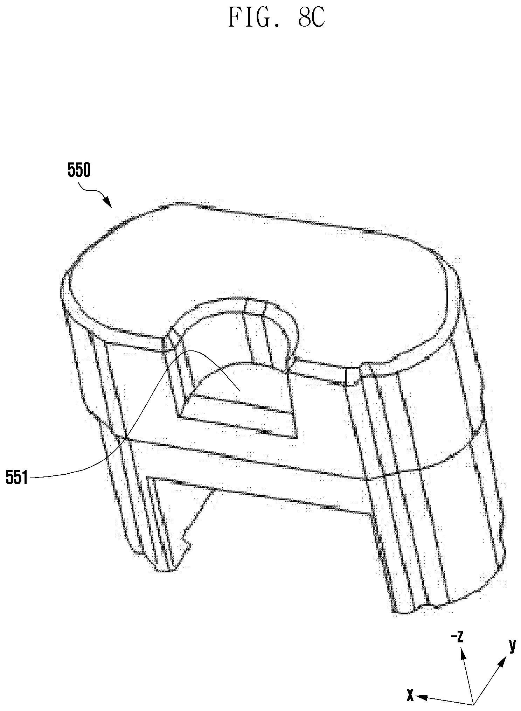

FIG. 8C is a perspective view of the fixing member 550 according to various embodiments.

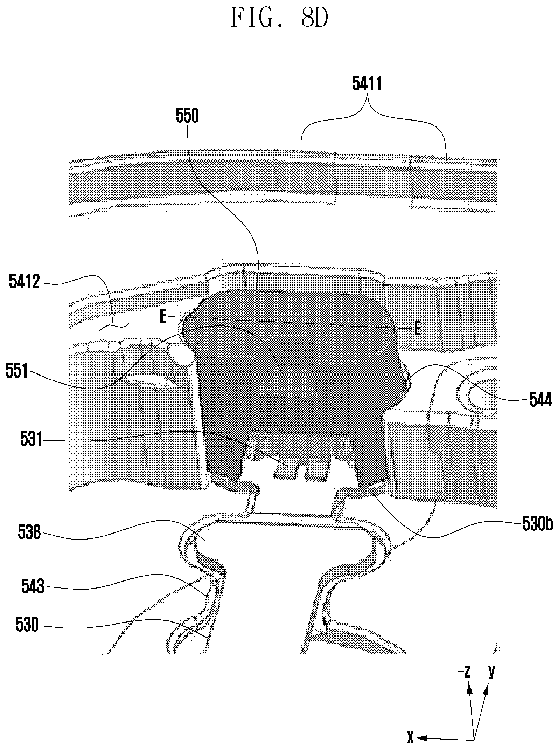

FIG. 8D is a perspective view of the electronic device 500 according to various embodiments.

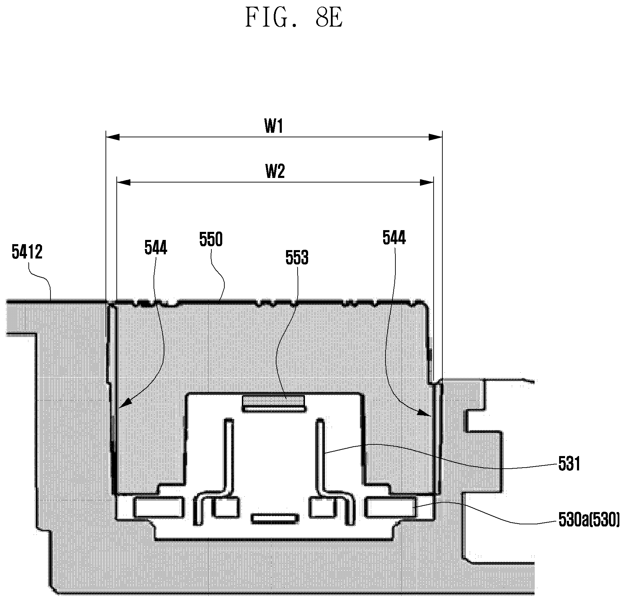

FIG. 8E is a cross-sectional view of the electronic device 500 according to various embodiments.

The cross section in FIG. 8B is a cross section taken in the D-D direction of FIG. 8A.

The cross section in FIG. 8E is a cross section taken in the E-E direction of FIG. 8D.

Referring to FIGS. 8A to 8C, the electronic device 500 may include the fixing member 550. The fixing member 550 may be a member which restricts the flexible printed circuit board 530 from moving in a direction (e.g., -z direction) perpendicular to a surface of the flexible printed circuit board 530.

When the flexible printed circuit board 530 receives a reaction of an elastic force of the contact member 531 and the movement of the flexible printed circuit board 530 in the direction of the reaction is restricted (for example, by the protrusion portion 538), the flexible printed circuit board 530 may move in the direction perpendicular to the surface of the flexible printed circuit board 530 due to the reaction. For example, a force which bends the flexible printed circuit board 530 may be generated. The fixing member 550 may prevent or reduce the flexible printed circuit board 530 from being separated from its proper position by restricting such movement, and thus the electrical contact between the contact member 531 and the antenna 508 may be stably maintained.

In various embodiments, the electrical component 520 (e.g., the camera 520a) may include a flange 524 which fixes the fixing member 550 in the direction (e.g., -z direction) perpendicular to the surface of the flexible printed circuit board 530. For example, the flange 524 may be disposed on the camera housing 521 of the camera 520a.

In various embodiments, the fixing member 550 may include a flange groove 551, and the flange 524 may be inserted into the flange groove 551. The flange groove 551 may be a groove formed to have a shape corresponding to the shape of the flange 524 on a surface in a direction (e.g., -z direction) in which the fixing member 550 comes into contact with the flange 524. The flange 524 is inserted into the flange groove 551, so that a separation of the fixing member 550 from a pressing force of the flange 524 may be prevented or reduced.

In various embodiments, the electronic device 500 may include an adhesive member 553 which bonds the fixing member 550 and the contact member 531 to each other. The adhesive member 553 may fix the fixing member 550 and the contact member 531 to each other to restrict the movement (e.g., tilt in the -z direction) of the contact member 531.

Referring to FIGS. 8D and 8E, the lateral frame 541 may include a fixing groove 544. The fixing groove 544 may be a groove formed to have a shape corresponding to the shape of the fixing member 550 so that the fixing member 550 is inserted and fixed.

In various embodiments, the fixing groove 544 may be configured so that the polymer injection portion 5412 of the lateral frame 541 is partially removed (e.g., by machining such as drilling) to expose inner surfaces of the metal segments 5411 inside the fixing groove 544, and the contact member 531 may form electrical contact with the exposed inner surfaces of the metal segments 5411. The fixing member 550 may reinforce the rigidity of the lateral frame 541 by being inserted into the fixing groove 544. When a part of the polymer injection portion 5412 of the lateral frame 541 is removed so that the metal segments 5411 and the contact member 531 are in contact with each other, the rigidity of the lateral frame 541 may be weakened, and the rigidity of the lateral frame 541 may be reinforced by inserting the fixing member 550 into the fixing groove 544.

In various embodiments, the fixing member 550 may be fixedly fitted through an interference fit in the fixing groove 544. For example, a width (W1) of the fixing member 550 may be larger than a width (W2) of the fixing groove 544. Therefore, the fixing member 550 may be firmly fixed by a friction force between the fixing member 550 and the fixing groove 544.

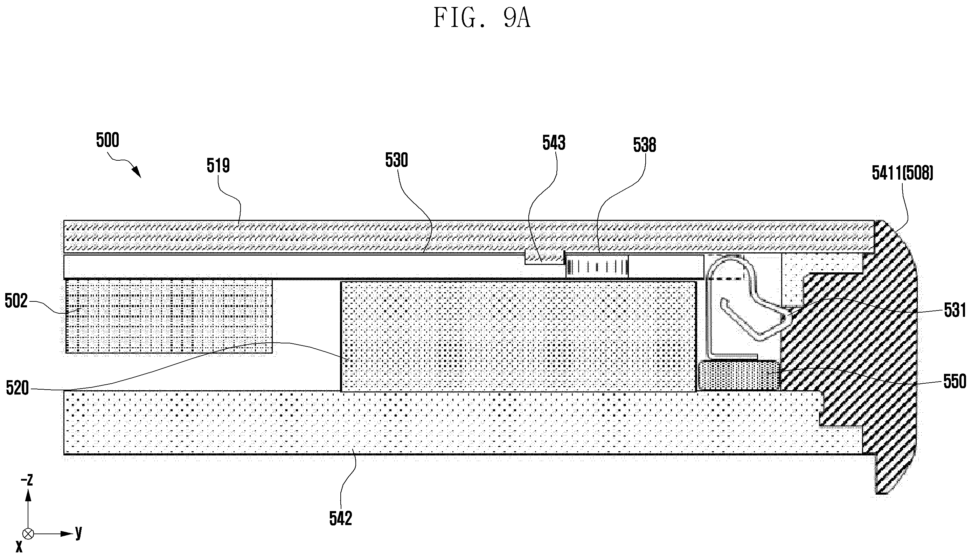

FIG. 9A is a cross-sectional view of the electronic device 500 according to various embodiments.

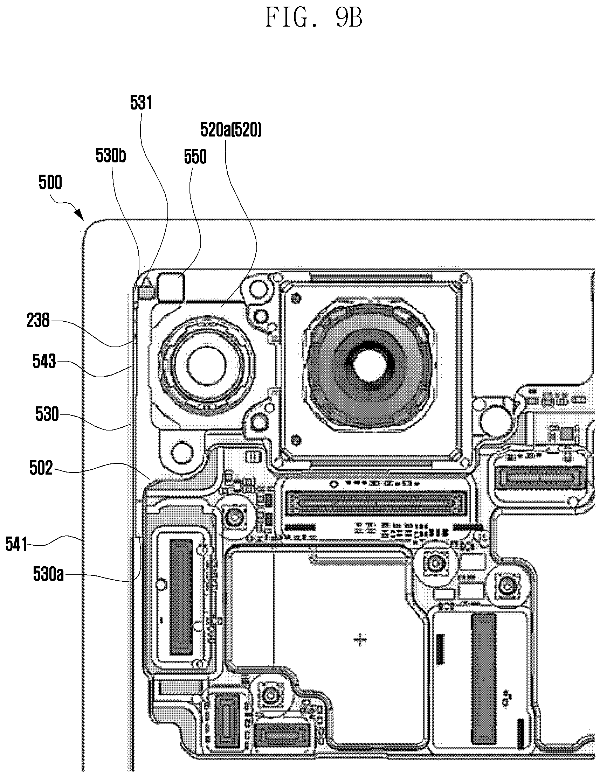

FIG. 9B is an internal plan view of the electronic device 500 according to various embodiments.

Referring to FIG. 9A, an electrical component of the electronic device 500 may be disposed so that one surface of the electrical component faces the rear plate of the electronic device 500, and the flexible printed circuit board 530 may extend along the one surface so that the metal segment 5411 and the contact member 531 are in contact with each other, between the rear plate and the one surface of the electrical component 520 facing the rear plate.

When a part of the electrical component is disposed in close contact with the support member 542, and there is not enough space for the flexible printed circuit board 530 to pass through between the support member 542 and the electrical component 520, the flexible printed circuit board 530 may pass through between the electrical component 520 and the rear plate. In various embodiments, the catching protrusion 543 may be configured in an area of the rear plate corresponding to the protrusion portion 538 of the flexible printed circuit board 530.

Referring to FIG. 9B, an electrical component of the electronic device 500 may be disposed so that one surface (e.g., a lateral surface) of the electrical component faces the lateral frame 541 of the electronic device 500, and the flexible printed circuit board 530 may extend along the lateral frame 541 between the lateral frame 541 and a surface of the electrical component 520 facing the lateral frame 541.

In various embodiments, the lateral frame 541 may have a shape of a polygon (hereinafter, including a polygon having rounded corners), such as a quadrangle shape. The flexible printed circuit board 530 may extend in a direction of a corner of the polygon along one side of the polygon. The second end portion 530b of the flexible printed circuit board 530 and the contact member 531 may be positioned at the corner. The contact member 531 may be in contact with the other side which meets the one side at the corner, inside the electronic device 500. In various embodiments, the catching protrusion 543 may be configured in an area of the lateral frame 541 corresponding to the protrusion portion 538 of the flexible printed circuit board 530. When the flexible printed circuit board 530 extends along the lateral frame 541, a space in a thickness direction (z-axis direction) is not occupied, and thus the thickness of the electronic device 500 may be reduced.

In addition, the embodiments disclosed in this document disclosed in the specification and drawings are provided only to provide a specific example in order to easily describe the technical content according to the embodiment disclosed in this document and to help understanding of the embodiment disclosed in this document, and are not intended to limit the scope of the embodiment disclosed in this document. Therefore, the scope of various embodiments disclosed in this document should be interpreted to include all changes or modified forms derived based on the various embodiments disclosed in this document in addition to the embodiments disclosed herein.

It will be appreciated that all of the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.
having a shape corresponding to the flange 524, and the flange 524 may be inserted into the flange groove 551.

In various embodiments, the lateral frame 541 may include a fixing groove 544 formed in an area where the contact member 531 is in contact with the at least one antenna 508 and having a shape at least partially corresponding to the fixing member 550, and the fixing member 550 may be fixed by being inserted into the fixing groove 544.

In various embodiments, a dimension of the fixing member 550 may be configured so that the fixing member 550 is fixedly fitted through an interference fit in an inner surface of the fixing groove 544.

In various embodiments, the fixing groove 544 may be formed by partially removing the polymer material to expose a surface of the antenna 508 facing an inside of the electronic device 500 in an area where the contact member 531 is in contact with the at least one antenna 508. The fixing member 550 may be configured to reinforce rigidity of the area where the polymer material has been partially removed by interference-fitting the fixing member 550 to an inner surface of the fixing groove 544.

In various embodiments, the electronic device 500 may include an adhesive member which is positioned between the fixing member 550 and the contact member 531, is adhered to the fixing member 550 and the contact member 531, and has an elastic material.

In various embodiments, the flexible printed circuit board 530 may extend through a portion between the rear plate 519 and one surface of the electrical component 520 facing the rear plate 519.

In various embodiments, the flexible printed circuit board 530 may extend through a portion between the lateral frame 541 and one surface of the electrical component 520 facing the lateral frame 541.

In various embodiments, the lateral frame 541 may have a polygonal shape. The flexible printed circuit board 530 may extend along one side of the polygonal shape, the second end portion 530b of the flexible printed circuit board 530 may be positioned at a corner portion of the polygonal shape of the lateral frame 541, and the contact member 531 may be oriented to apply an elastic force to a surface of another side which meets the side at the corner portion of the polygonal shape.

An electronic device 500 according to various embodiments of the disclosure may include a housing 510 including at least one metal segment 5411 disposed on a lateral surface thereof and having an internal space, a support member 542 extending from the lateral surface of the housing 510 into the internal space, at least one electrical component 520 which is at least partially disposed in the internal space, a wireless communication module positioned in the internal space, a flexible printed circuit board 530 having first end portion 530a electrically connected to the wireless communication module and the second end portion 530b extending to be adjacent to the at least one antenna 508, and a contact member 531 which is disposed in the second end portion 530b of the flexible printed circuit board 530, in electrical contact with the at least one antenna 508, and oriented to apply an elastic force in a direction parallel to a surface of the flexible printed circuit board 530.

The flexible printed circuit board 530 may extend so that the second end portion 530b is adjacent to the metal segment 5411 between the support member 542 and one surface of the electrical component 520 facing the support member 542, and include a protrusion portion 538 formed by increase of a width of a part of the flexible printed circuit board 530 adjacent to the second end portion 530b, and the support member 542 may include a catching protrusion 543 positioned in an area corresponding to the protrusion portion 538 and formed to allow the protrusion portion 538 to be caught thereby. That is, the catching protrusion 543 is configured to abut or contact with the protrusion portion 538 to prevent a movement of the protrusion portion 538 past the catching protrusion 543.

In various embodiments, the electronic device 500 may include a fixing member 550 positioned in a first direction perpendicular to the surface of the flexible printed circuit board 530 from the contact member 531 and configured to fix the contact member 531 with respect to the first direction.

In various embodiments, the electrical component 520 may include a flange 524 extending to be positioned in the first direction with respect to the fixing member 550, and the flange 524 may fix the fixing member 550 with respect to the first direction.

In various embodiments, the housing 510 may include a fixing groove 544 formed in an area where the contact member 531 is in contact with the at least one antenna 508 and having a shape at least partially corresponding to the fixing member 550, and the fixing member 550 may be fixed by being inserted into the fixing groove 544.

In various embodiments, a dimension of the fixing member 550 may be configured so that the fixing member 550 is fixedly fitted through an interference fit in an inner surface of the fixing groove 544.

A flexible printed circuit board 530 according to various embodiments of the disclosure is a flexible printed circuit board 530 of an electronic device 500, and the electronic device 500 may include a housing 510 including at least one metal segment 5411 disposed on a lateral surface thereof and having an internal space, a support member 542 extending from the lateral surface of the housing 510 into the internal space, a wireless communication module positioned in the internal space, and a catching protrusion 543 formed in an area of the support member 542 adjacent to the metal segment 5411. The flexible printed circuit board 530 may include a connector 539 disposed in first end portion 530a of the flexible printed circuit board 530 and configured to be electrically connected to the communication module, a contact member 531 disposed in the second end portion 530b of the flexible printed circuit board 530 and including a pin configured to apply an elastic force in a direction parallel to a surface of the flexible printed circuit board 530, and a protrusion portion 538 formed by increase of a width of an area of the flexible printed circuit board 530 adjacent to the second end portion 530b, and formed to be caught by the catching protrusion 543.

In addition, the embodiments disclosed in this document disclosed in the specification and drawings are provided only to provide a specific example in order to easily describe the technical content according to the embodiment disclosed in this document and to help understanding of the embodiment disclosed in this document, and are not intended to limit the scope of the embodiment disclosed in this document. Therefore, the scope of various embodiments disclosed in this document should be interpreted to include all changes or modified forms derived based on the various embodiments disclosed in this document in addition to the embodiments disclosed herein.

It will be appreciated that all of the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.

## Claims

1. An electronic device (500) comprising:
a frame (540) comprising at least one antenna (508) and comprising a metal material and a polymer material;
a front plate (518) coupled to the frame (540);
a rear plate (519) coupled to the frame (540);
at least one electrical component (520) at least partially disposed in an internal space defined by the frame (540), the front plate (518), and the rear plate (519);
a support member (542) extending from the frame into the internal space and facing the at least one electrical component (520);
a printed circuit board (502) disposed in the internal space;
a flexible printed circuit board (530) having a first end portion (530a) electrically connected to the printed circuit board (502) and a second end portion (530b) adjacent to the at least one antenna (508); and
a contact member (531) disposed on the second end portion (530b) of the flexible printed circuit board (530) and contacting the at least one antenna (508) to apply a force caused by elastic deformation of the contact member (531) on the at least one antenna (508), and
**characterised in that**
the flexible printed circuit board (530) comprises a protrusion portion (538), the protrusion portion (538) formed to protrude in a width direction of the second end portion (530b) in an area adjacent to the second end portion (530b), and
wherein the support member (542) comprises a recess (543), the recess (543) is configured to engage with the protrusion portion (538) of the flexible printed circuit board (530) so as to restrict movement of the flexible printed circuit board (530) in a direction away from the at least one antenna (508) when the contact member (531) applies the force caused by elastic deformation of the contact member (531).

2. The electronic device of claim 1, wherein the frame (540) comprises a lateral frame (541) positioned on a lateral surface of the electronic device (500) and comprising a plurality of metal segments (5411) and a polymer injection portion (5412) coupled to the metal segments (5411), and the support member (542) coupled to the lateral frame (541) and extending from the lateral frame (541) into an inside of the electronic device (500), and
wherein the at least one antenna (508) is at least one of the plurality of metal segments (5411).

3. The electronic device of claim 2, wherein the flexible printed circuit board (530) extends through a portion between the support member (542) and the one surface of the electrical component (520).

4. The electronic device of claim 2, further comprising a fixing member (550) positioned in a thickness direction from the contact member (531) and configured to fix the contact member (531) with respect to the thickness direction.

5. The electronic device of claim 4, wherein the electrical component (520) comprises a flange (524) extending to be positioned in the thickness direction with respect to the fixing member (550), and the flange (524) is configured to fix the fixing member (550) with respect to the thickness direction.

6. The electronic device of claim 5, wherein the fixing member (550) comprises a flange groove (551) having a shape corresponding to the flange (524), and
wherein the flange (524) is inserted into the flange groove (551).

7. The electronic device of any of claims 4 to 6, wherein the lateral frame (541) comprises a fixing groove (544) formed in an area where the contact member (531) is in contact with the at least one antenna (508) and having a shape at least partially corresponding to the fixing member (550), and
wherein the fixing member (550) is fixed by being inserted into the fixing groove (544).

8. The electronic device of claim 7, wherein a dimension of the fixing member (550) is configured so that the fixing member (550) is fixedly fitted through an interference fit in an inner surface of the fixing groove (544).

9. The electronic device of claim 7 or claim 8, wherein the fixing groove (544) is formed by partially removing the polymer material to expose a surface of the antenna (508) facing an inside of the electronic device (500) in an area where the contact member (531) is in contact with the at least one antenna (508), and
wherein the fixing member (550) is configured to reinforce rigidity of the area where the polymer material has been partially removed by interference-fitting the fixing member (550) to the inner surface of the fixing groove (544).

10. The electronic device of any of claims 4 to 9, comprising an adhesive member positioned between the fixing member (550) and the contact member (531), adhered to the fixing member (550) and the contact member (531), and comprising an elastic material.

11. The electronic device of any of the preceding claims, wherein the flexible printed circuit board (530) extends through a portion between the rear plate (519) and one surface of the electrical component (520) facing the rear plate (519).

12. The electronic device of claim 2, wherein the flexible printed circuit board (530) extends through a portion between the lateral frame (541) and one surface of the electrical component (520) facing the lateral frame (541).

13. The electronic device of claim 12, wherein the lateral frame (541) has a polygonal shape,
wherein the flexible printed circuit board (530) extends along one side of the polygonal shape,
wherein the second end portion (530b) of the flexible printed circuit board (530) is positioned at a corner portion of the polygonal shape of the lateral frame (541), and
wherein the contact member (531) is oriented to apply the force caused by elastic deformation of the contact member (531) to a surface of another side which meets the side at the corner portion of the polygonal shape.

14. The electronic device of claim 1, wherein the recess (543) being formed by recessing, in a thickness direction, a surface of the support member (542) overlapping the protrusion portion (538) of the flexible printed circuit board (530), or by forming, in the thickness direction a peripheral part of the surface of the support member (542) overlapping the protrusion portion (538) to protrude.

## Patentansprüche

1. Elektronische Vorrichtung (500), umfassend:
einen Rahmen (540), der mindestens eine Antenne (508) umfasst und ein Metallmaterial und ein Polymermaterial umfasst;
eine vordere Platte (518), die an den Rahmen (540) gekoppelt ist;
eine hintere Platte (519), die an den Rahmen (540) gekoppelt ist;
mindestens eine elektrische Komponente (520), die mindestens teilweise in einem Innenraum angeordnet ist, der durch den Rahmen (540), die vordere Platte (518) und die hintere Platte (519) definiert ist;
ein Stützelement (542), das sich von dem Rahmen in den Innenraum erstreckt und der mindestens einen elektrischen Komponente (520) zugewandt ist;
eine gedruckte Leiterplatte (502), die in dem Innenraum angeordnet ist;
eine flexible gedruckte Leiterplatte (530), die einen ersten Endabschnitt (530a), der elektrisch mit der gedruckten Leiterplatte (502) verbunden ist, und einen zweiten Endabschnitt (530b) aufweist, der benachbart zu der mindestens einen Antenne (508) ist; und
ein Kontaktelement (531), das an dem zweiten Endabschnitt (530b) der flexiblen gedruckten Leiterplatte (530) angeordnet ist und mit der mindestens eine Antenne (508) in Kontakt tritt, um eine Kraft aufzubringen, die durch eine elastische Verformung des Kontaktelements (531) auf die mindestens eine Antenne (508) verursacht wird, und **dadurch gekennzeichnet, dass**
die flexible gedruckte Leiterplatte (530) einen Vorsprungsabschnitt (538) umfasst, wobei der Vorsprungsabschnitt (538) gebildet ist, um in einer Breitenrichtung des zweiten Endabschnitts (530b) in einem Bereich benachbart zu dem zweiten Endabschnitt (530b) vorzustehen, und
wobei das Stützelement (542) eine Aussparung (543) umfasst, die Aussparung (543) dazu konfiguriert ist, mit dem Vorsprungsabschnitt (538) der flexiblen gedruckten Leiterplatte (530) in Eingriff zu treten, um eine Bewegung der flexiblen gedruckten Leiterplatte (530) in einer Richtung von der mindestens einen Antenne (508) weg zu beschränken, wenn das Kontaktelement (531) die Kraft aufbringt, die durch elastische Verformung des Kontaktelements (531) verursacht wird.

2. Elektronische Vorrichtung nach Anspruch 1, wobei der Rahmen (540) einen Seitenrahmen (541) umfasst, der an einer Seitenfläche der elektronischen Vorrichtung (500) positioniert ist und eine Vielzahl von Metallsegmenten (5411) und einen Polymerinjektionsabschnitt (5412) umfasst, der an die Metallsegmente (5411) gekoppelt ist, und das Stützelement (542) an den Seitenrahmen (541) gekoppelt ist und sich von dem Seitenrahmen (541) in eine Innenseite der elektronischen Vorrichtung (500) erstreckt, und
wobei die mindestens eine Antenne (508) mindestens eines von der Vielzahl von Metallsegmenten (5411) ist.

3. Elektronische Vorrichtung nach Anspruch 2, wobei sich die flexible gedruckte Leiterplatte (530) durch einen Abschnitt zwischen dem Stützelement (542) und der einen Fläche der elektrischen Komponente (520) erstreckt.

4. Elektronische Vorrichtung nach Anspruch 2, ferner umfassend ein Fixierelement (550), das in einer Dickenrichtung von dem Kontaktelement (531) positioniert und dazu konfiguriert ist, das Kontaktelement (531) in Bezug auf die Dickenrichtung zu fixieren.

5. Elektronische Vorrichtung nach Anspruch 4, wobei die elektrische Komponente (520) einen Flansch (524) umfasst, der sich erstreckt, um in Bezug auf das Fixierelement (550) in der Dickenrichtung positioniert zu werden, und der Flansch (524) dazu konfiguriert ist, das Fixierelement (550) in Bezug auf die Dickenrichtung zu fixieren.

6. Elektronische Vorrichtung nach Anspruch 5, wobei das Fixierelement (550) eine Flanschnut (551) umfasst, die eine Form aufweist, die dem Flansch (524) entspricht, und wobei der Flansch (524) in die Flanschnut (551) eingesetzt ist.

7. Elektronische Vorrichtung nach einem der Ansprüche 4 bis 6, wobei der Seitenrahmen (541) eine Fixiernut (544) umfasst, die in einem Bereich gebildet ist, in dem das Kontaktelement (531) mit der mindestens einen Antenne (508) in Kontakt steht, und eine Form aufweist, die mindestens teilweise dem Fixierelement (550) entspricht, und
wobei das Fixierelement (550) durch Einsetzen in die Fixiernut (544) fixiert wird.

8. Elektronische Vorrichtung nach Anspruch 7, wobei eine Abmessung des Fixierelements (550) derart konfiguriert ist, dass das Fixierelement (550) durch eine Presspassung in einer Innenfläche der Fixiernut (544) fest eingepasst ist.

9. Elektronische Vorrichtung nach Anspruch 7 oder Anspruch 8, wobei die Fixiernut (544) durch partielles Entfernen des Polymermaterials gebildet ist, um eine Fläche der Antenne (508) freizulegen, die einer Innenseite der elektronischen Vorrichtung (500) in einem Bereich zugewandt ist, in dem das Kontaktelement (531) mit der mindestens einen Antenne (508) in Kontakt steht, und
wobei das Fixierelement (550) dazu konfiguriert ist, die Steifigkeit des Bereichs, in dem das Polymermaterial teilweise entfernt wurde, durch Presspassung des Fixierelements (550) an der Innenfläche der Fixiernut (544) zu verstärken.

10. Elektronische Vorrichtung nach einem der Ansprüche 4 bis 9, umfassend ein Haftelement, das zwischen dem Fixierelement (550) und dem Kontaktelement (531) positioniert ist, an dem Fixierelement (550) und dem Kontaktelement (531) haftet und ein elastisches Material umfasst.

11. Elektronische Vorrichtung nach einem der vorhergehenden Ansprüche, wobei sich die flexible gedruckte Leiterplatte (530) durch einen Abschnitt zwischen der hinteren Platte (519) und einer der hinteren Platte (519) zugewandten Fläche der elektrischen Komponente (520) erstreckt.

12. Elektronische Vorrichtung nach Anspruch 2, wobei sich die flexible gedruckte Leiterplatte (530) durch einen Abschnitt zwischen dem Seitenrahmen (541) und einer Fläche der elektrischen Komponente (520) erstreckt, die dem Seitenrahmen (541) zugewandt ist.

13. Elektronische Vorrichtung nach Anspruch 12, wobei der Seitenrahmen (541) eine polygonale Form aufweist,
wobei sich die flexible gedruckte Leiterplatte (530) entlang einer Seite der polygonalen Form erstreckt,
wobei der zweite Endabschnitt (530b) der flexiblen gedruckten Leiterplatte (530) an einem Eckabschnitt der polygonalen Form des Seitenrahmens (541) positioniert ist und
wobei das Kontaktelement (531) ausgerichtet ist, um die Kraft, die durch elastische Verformung des Kontaktelements (531) verursacht wird, auf eine Fläche einer anderen Seite auszuüben, die an dem Eckabschnitt der polygonalen Form auf die Seite trifft.

14. Elektronische Vorrichtung nach Anspruch 1, wobei die Aussparung (543) dadurch gebildet ist, dass eine Fläche des Stützelements (542), die den Vorsprungsabschnitt (538) der flexiblen gedruckten Leiterplatte (530) überlappt, in einer Dickenrichtung ausgespart ist, oder dadurch, dass ein Umfangsteil der Fläche des Stützelements (542), die den Vorsprungsabschnitt (538) überlappt, in der Dickenrichtung gebildet ist, um vorzustehen.

## Revendications

1. Dispositif électronique (500) comprenant :
un cadre (540) comprenant au moins une antenne (508) et comprenant un matériau métallique et un matériau polymère ;
une plaque avant (518) couplée au cadre (540) ;
une plaque arrière (519) couplée au cadre (540) ;
au moins un composant électrique (520) au moins partiellement disposé dans un espace interne défini par le cadre (540), la plaque avant (518) et la plaque arrière (519) ;
un élément de support (542) s'étendant à partir du cadre dans l'espace interne et faisant face à l'au moins un composant électrique (520) ;
une carte de circuit imprimé (502) disposée dans l'espace interne ;
une carte de circuit imprimé flexible (530) présentant une première partie d'extrémité (530a) électriquement connectée à la carte de circuit imprimé (502) et une seconde partie d'extrémité (530b) adjacente à l'au moins une antenne (508) ; et
un élément de contact (531) disposé sur la seconde partie d'extrémité (530b) de la carte de circuit imprimé flexible (530) et entrant en contact avec l'au moins une antenne (508) pour appliquer une force entraînée par la déformation élastique de l'élément de contact (531) sur l'au moins une antenne (508), et
**caractérisé en ce que**
la carte de circuit imprimé flexible (530) comprend une partie saillante (538), la partie saillante (538) étant formée pour faire saillie dans une direction de largeur de la seconde partie d'extrémité (530b) dans une zone adjacente à la seconde partie d'extrémité (530b), et
dans lequel l'élément de support (542) comprend un évidement (543), l'évidement (543) étant conçu pour venir en prise avec la partie saillante (538) de la carte de circuit imprimé flexible (530) de façon à limiter un mouvement de la carte de circuit imprimé flexible (530) dans une direction s'éloignant de l'au moins une antenne (508) lorsque l'élément de contact (531) applique la force entraînée par la déformation élastique de l'élément de contact (531).

2. Dispositif électronique de la revendication 1, dans lequel le cadre (540) comprend un cadre latéral (541) positionné sur une surface latérale du dispositif électronique (500) et comprenant une pluralité de segments métalliques (5411) et une partie d'injection de polymère (5412) couplée aux segments métalliques (5411), et l'élément de support (542) couplé au cadre latéral (541) et s'étendant à partir du cadre latéral (541) dans un intérieur du dispositif électronique (500), et
dans lequel l'au moins une antenne (508) est au moins l'un de la pluralité de segments métalliques (5411).

3. Dispositif électronique de la revendication 2, dans lequel la carte de circuit imprimé flexible (530) s'étend à travers une partie entre l'élément de support (542) et l'une surface du composant électrique (520).

4. Dispositif électronique de la revendication 2, comprenant en outre un élément de fixation (550) positionné dans une direction d'épaisseur à partir de l'élément de contact (531) et conçu pour fixer l'élément de contact (531) par rapport à la direction d'épaisseur.

5. Dispositif électronique de la revendication 4, dans lequel le composant électrique (520) comprend une bride (524) s'étendant pour être positionnée dans la direction d'épaisseur par rapport à l'élément de fixation (550), et la bride (524) est conçue pour fixer l'élément de fixation (550) par rapport à la direction d'épaisseur.

6. Dispositif électronique de la revendication 5, dans lequel l'élément de fixation (550) comprend une rainure de bride (551) présentant une forme correspondant à la bride (524), et dans lequel la bride (524) est insérée dans la rainure de bride (551).

7. Dispositif électronique de l'une quelconque des revendications 4 à 6, dans lequel le cadre latéral (541) comprend une rainure de fixation (544) formée dans une zone où l'élément de contact (531) est en contact avec l'au moins une antenne (508) et présentant une forme correspondant au moins partiellement à l'élément de fixation (550), et
dans lequel l'élément de fixation (550) est fixé en étant inséré dans la rainure de fixation (544).

8. Dispositif électronique de la revendication 7, dans lequel une dimension de l'élément de fixation (550) est conçue afin que l'élément de fixation (550) soit ajusté de manière fixe au travers d'un ajustement serré dans une surface intérieure de la rainure de fixation (544).

9. Dispositif électronique de la revendication 7 ou de la revendication 8, dans lequel la rainure de fixation (544) est formée en retirant partiellement le matériau polymère pour exposer une surface de l'antenne (508) faisant face à un intérieur du dispositif électronique (500) dans une zone où l'élément de contact (531) est en contact avec l'au moins une antenne (508), et
dans lequel l'élément de fixation (550) est conçu pour renforcer une rigidité de la zone où le matériau polymère a été partiellement retiré par ajustement serré de l'élément de fixation (550) sur la surface intérieure de la rainure de fixation (544).

10. Dispositif électronique de l'une quelconque des revendications 4 à 9, comprenant un élément adhésif positionné entre l'élément de fixation (550) et l'élément de contact (531), adhérant à l'élément de fixation (550) et à l'élément de contact (531), et comprenant un matériau élastique.

11. Dispositif électronique de l'une quelconque des revendications précédentes, dans lequel la carte de circuit imprimé flexible (530) s'étend à travers une partie entre la plaque arrière (519) et une surface du composant électrique (520) faisant face à la plaque arrière (519).

12. Dispositif électronique de la revendication 2, dans lequel la carte de circuit imprimé flexible (530) s'étend à travers une partie entre le cadre latéral (541) et une surface du composant électrique (520) faisant face au cadre latéral (541).

13. Dispositif électronique de la revendication 12, dans lequel le cadre latéral (541) présente une forme polygonale,
dans lequel la carte de circuit imprimé flexible (530) s'étend le long d'un côté de la forme polygonale,
dans lequel la seconde partie d'extrémité (530b) de la carte de circuit imprimé flexible (530) est positionnée au niveau d'une partie d'angle de la forme polygonale du cadre latéral (541), et
dans lequel l'élément de contact (531) est orienté pour appliquer la force entraînée par la déformation élastique de l'élément de contact (531) sur une surface d'un autre côté qui rencontre le côté au niveau de la partie d'angle de la forme polygonale.

14. Dispositif électronique de la revendication 1, dans lequel l'évidement (543) est formé en évidant, dans une direction d'épaisseur, une surface de l'élément de support (542) chevauchant la partie saillante (538) de la carte de circuit imprimé flexible (530), ou en formant, dans la direction d'épaisseur, une pièce périphérique de la surface de l'élément de support (542) chevauchant la partie saillante (538) pour faire saillie.
